# EUROPEAN PATENT SPECIFICATION

(11) **EP 4 343 348 B1**
(45) Date of publication and mention of the grant of the patent: **04.11.2026**
(21) Application number: 23197002.1
(22) Date of filing: 12.09.2023
(51) Int. Cl.: G01R 31/36

(54) **METHODS AND SYSTEMS FOR MITIGATING BATTERY DEFECTS**
VERFAHREN UND SYSTEME ZUR MINDERUNG VON BATTERIEDEFEKTEN
PROCÉDÉS ET SYSTÈMES POUR ATTÉNUER DES DÉFAUTS DE BATTERIE

(30) Priority: 16.09.2022 US 202263375967 P; 01.12.2022 US 202218060834
(43) Date of publication of application: 27.03.2024
(73) Proprietor: Qnovo Inc., Milpitas, CA 95035 (US)
(72) Inventor: CHANG, On K, Milpitas, 95035 (US); SUMMY, Dustin, Milpitas, 95035 (US); HOANG, Khanh, Milpitas, 95035 (US); GHANTOUS, Dania, Milpitas, 95035 (US); BERKOWITZ, Fred, Milpitas, 95035 (US); MALUF, Nadim, Los Altos, 94022 (US)
(74) Representative: Haseltine Lake Kempner LLP

(56) References cited:
- US-A1- 2007 182 418
- US-A1- 2016 116 548
- US-A1- 2020 014 218
- US-A1- 2022 187 385

## Description

### BACKGROUND

Batteries may be susceptible to a variety of defects. These defects may be due to aging, improper use (e.g., charging and/or discharging) of the battery, and/or manufacturing defects. Detection of battery defects is important, for example, to prevent dangerous battery conditions, to extend battery life, etc. However, it can be difficult to detect battery defects.

The background description provided herein is for the purposes of generally presenting the context of the disclosure. Work of the presently named inventors, to the extent it is described in this background section, as well as aspects of the description that may not otherwise qualify as prior art at the time of filing, are neither expressly nor impliedly admitted as prior art against the present disclosure.

US2007182418A1 discusses systems and methods for characterizing thermodynamic and materials properties of electrodes and electrochemical energy storage and conversion systems to enable identification and characterization of phase transitions, crystallite size, surface and bulk defects and crystal structure defects in electrode materials. For example, an open circuit voltage analyzer calculates observed rate of change in open circuit voltage per unit time for a selected electrochemical cell temperature and composition combination and compares the absolute value of the observed rates of change in open circuit voltage per unit time to a threshold rate of change in open circuit voltage per unit time. The analyzer determines that an open circuit voltage is equal to the open circuit voltage of the electrochemical cell for thermochemically stabilized conditions for the selected electrochemical cell temperature and composition combination when the absolute value of the observed rate of change in open circuit voltage per unit time is equal to or less than the threshold rate of change in open circuit voltage per unit time. US2016116548A1 discusses methods and systems for measuring and managing swelling of rechargeable batteries *in situ,* which can use capacity fade or state of health of rechargeable batteries to estimate swelling of the rechargeable batteries. US2022187385A1 discusses a method for estimating the state of health of an electrochemical element, comprising: initiating a charging or discharging operation of the electrochemical element; measuring values representing deformations of the electrochemical element while the charging or discharging operation is being performed, the deformation values measured forming a deformations image signal according to the quantity of electricity passing through the electrochemical element over time; comparing the deformations image signal and a reference image signal, one or more differences obtained by the comparison characterising an estimation of the ageing of the electrochemical element. US2020014218A1 discusses a method for identifying a battery type and/or a battery user. The method may use measuring circuitry to collect battery parameters that may be analyzed by control circuitry to create an adaptive charge profile that is applied to a battery by charging circuitry. Battery parameters may be recorded in a battery use signature. Logic may be used to process a battery use signature and identify a single user across multiple battery operated devices and/or discriminate between multiple users of a device.

### SUMMARY

Methods and systems for mitigating battery defects are provided. In accordance with claim 1, a method of diagnosing battery defects is provided.

In some examples, the obtained rate of change occurs over at least 2 cycles of the rechargeable battery.

In accordance with claim 1, determining the defect status of the rechargeable battery comprises comparing the rate of change of the at least one battery parameter to an expected rate of change of the at least one battery parameter. In accordance with claim 1, the comparing occurs at a predetermined state of charge (SOC) or range of SOC, and/or the expected rate of change of the at least one battery parameter is based at least in part on an output of a battery model and/or historical data from other rechargeable batteries. In some examples, the battery model comprises one of more of: an equivalent circuit model of the rechargeable battery; a machine learning model; or a mathematical expression. In some examples, the battery model is specific to a type of battery corresponding to the rechargeable battery. In some examples, the type of battery corresponds to at least one of: a battery chemistry associated with the rechargeable battery; a vendor of the rechargeable battery, or a cell design associated with the rechargeable battery. In some examples, the battery model is applicable to a particular regime of use of the rechargeable battery. In some examples, the regime of use comprises at least one of: a range of states of charge (SOCs); a constant current portion of a charging protocol; or a constant voltage portion of the charging protocol. In some examples, the regime of use comprises at least a portion of a discharging protocol.

In some examples, determining the defect status of the rechargeable battery comprises considering a previous use pattern of the rechargeable battery. In some examples, the previous use pattern comprises at least one of: a temperature of the rechargeable battery; storage conditions of the rechargeable battery; charging patterns of the rechargeable battery; discharge patterns of the rechargeable battery; or a number of charging cycles of the rechargeable battery. In some examples, the charging patterns comprise at least one of a charge rate or a depth of charge. In some examples, the discharge patterns comprise at least one of a discharge rate or a depth of discharge.

In some examples, the one or more battery parameters comprise at least one of: an open circuit voltage of the rechargeable battery, a loaded circuit voltage of the rechargeable battery, a charge pulse voltage of the rechargeable battery, electrochemical impedance spectroscopy (EIS) information associated with the rechargeable battery, a capacity of the rechargeable battery, impedance information associated with the rechargeable battery, or a current associated with the rechargeable battery.

In some examples, the method further comprises modifying a use pattern of the rechargeable battery based at least in part on the determined defect status of the rechargeable battery. In some examples, modifying the use pattern comprises at least one of: modifying a charging process used to charge the rechargeable battery; modifying a discharge process used in discharging the rechargeable battery; or modifying a temperature of the rechargeable battery. In some examples, modifying the charging process comprises temporarily prohibiting charging of the rechargeable battery. In some examples, modifying the charging process comprises reducing a charging voltage and/or a charging current. In some examples, the modified use pattern is applicable to a given state of charge (SOC) of the rechargeable battery or a range of SOCs of the rechargeable battery.

In accordance with claim 11, an apparatus for mitigating battery defects comprises: monitoring circuitry, coupled to a rechargeable battery, configured to monitor one or more battery parameters associated with the rechargeable battery; and control circuitry coupled to the monitoring circuitry, wherein the apparatus is configured to carry out the method according to any one of claims 1-10. The control circuitry is configured to: obtain a rate of change of at least one battery parameter of the one or more battery parameters; and determine a defect status of the rechargeable battery based at least in part on the rate of change of the at least one battery parameter.

In some examples, the obtained rate of change occurs over at least 2 cycles of the rechargeable battery.

In accordance with claim 11, to determine the defect status of the rechargeable battery, the control circuitry is configured to compare the rate of change of the at least one battery parameter to an expected rate of change of the at least one battery parameter, wherein the comparing occurs at a predetermined state of charge (SOC) or range of SOC, and/or the expected rate of change of the at least one battery parameter is based at least in part on an output of a battery model and/or historical data from other rechargeable batteries. In some examples, the battery model comprises one of more of: an equivalent circuit model of the rechargeable battery; a machine learning model; or a mathematical expression. In some examples, the battery model is specific to a type of battery corresponding to the rechargeable battery. In some examples, the type of battery corresponds to at least one of: a battery chemistry associated with the rechargeable battery; a vendor of the rechargeable battery, or a cell design associated with the rechargeable battery. In some examples, the battery model is applicable to a particular regime of use of the rechargeable battery. In some examples, the regime of use comprises at least one of: a range of states of charge (SOCs); a constant current portion of a charging protocol; or a constant voltage portion of the charging protocol. In some examples, the regime of use comprises at least a portion of a discharging protocol.

In some examples, to determine the defect status of the rechargeable battery, the control circuitry is configured to consider a previous use pattern of the rechargeable battery. In some examples, the previous use pattern comprises at least one of: a temperature of the rechargeable battery; storage conditions of the rechargeable battery; charging patterns of the rechargeable battery; discharge patterns of the rechargeable battery; or a number of charging cycles of the rechargeable battery. In some examples, the charging patterns comprise at least one of a charge rate or a depth of charge. In some examples, the discharge patterns comprise at least one of a discharge rate or a depth of discharge.

In some examples, the one or more battery parameters comprise at least one of: an open circuit voltage of the rechargeable battery, a loaded circuit voltage of the rechargeable battery, a charge pulse voltage of the rechargeable battery, electrochemical impedance spectroscopy (EIS) information associated with the rechargeable battery, a capacity of the rechargeable battery, impedance information associated with the rechargeable battery, or a current associated with the rechargeable battery.

In some examples, the control circuitry is further configured to modify a use pattern of the rechargeable battery based at least in part on the determined defect status of the rechargeable battery. In some examples, to modify the use pattern, the control circuitry is configured to perform at least one of: modifying a charging process used to charge the rechargeable battery; modifying a discharge process used in discharging the rechargeable battery; or modifying a temperature of the rechargeable battery. In some examples, to modify the charging process, the control circuitry is configured to temporarily prohibit charging of the rechargeable battery. In some examples, to modify the charging process, the control circuitry is configured to reduce a charging voltage and/or a charging current. In some examples, the modified use pattern is applicable to a given state of charge (SOC) of the rechargeable battery or a range of SOCs of the rechargeable battery.

These and other features of the disclosure will be presented in more detail below with reference to the associated drawings.

### BRIEF DESCRIPTION OF THE DRAWINGS

In the course of the descriptions to follow, reference will be made to the attached drawings. These drawings show different aspects of some implementations, and where appropriate, reference numerals illustrating like structures, components, materials and/or elements in different figures are labeled similarly. It is understood that various combinations of the structures, components, and/or elements, other than those specifically shown, are contemplated and are within the scope of the present disclosure.

The present disclosures are neither limited to any single aspect nor embodiment thereof, nor to any combinations and/or permutations of such aspects and/or embodiments. Moreover, each of the aspects of the present disclosures, and/or embodiments thereof, may be employed alone or in combination with one or more of the other aspects of the present disclosures and/or embodiments thereof. For the sake of brevity, certain permutations and combinations are not discussed and/or illustrated separately herein.
**Figure** 1 illustrates, in block diagram form a "battery charging system" or a "battery monitoring system" in conjunction with a battery where charging circuitry 112 (including, e.g., a voltage source and/or current source ) responds to control circuitry 116 which receives battery information from monitoring circuitry 114 (including, e.g., a voltmeter and/or a current meter).

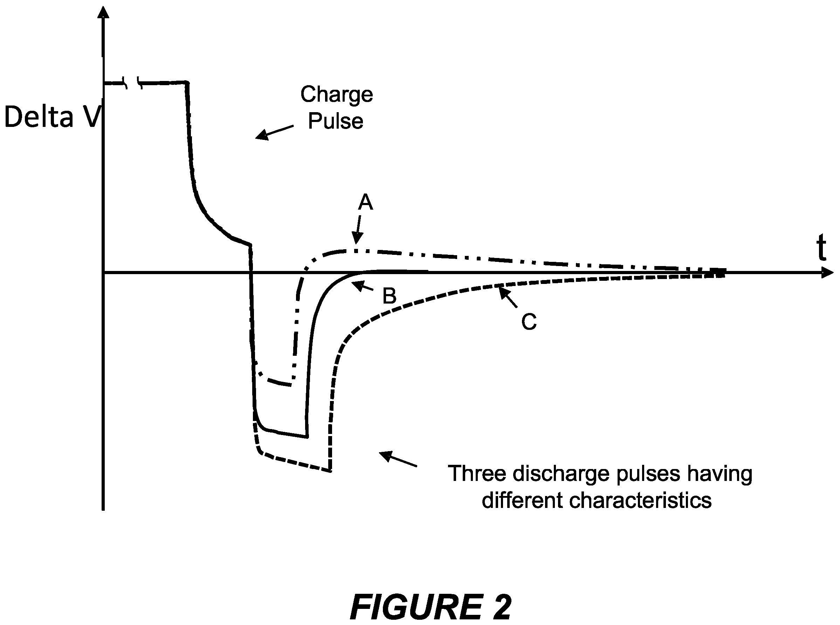

**Figure** 2 is an illustration depicting three responses to a charge pulse (which injects charge into the battery) and a discharge pulse (which removes charge from the battery) wherein a first response (A) includes a significant "overshoot" whereby the discharge pulse removed too little charge from the battery, a second response (B) includes no significant "overshoot" or "undershoot" wherein the discharge pulse removes a suitable amount of charge which provides the fastest partial relaxation time of the three responses, and a third response (C) includes a significant "undershoot" whereby the discharge pulse removes too much charge from the battery.
**Figures 3a-3d** illustrate current waveforms of charge signals that may be used to charge a battery.
**Figures 4a****-b** depict current and voltage waveforms resulting from charging a battery using a constant-current constant-voltage (CCCV) technique and an adapted CCCV technique which includes a plurality of constant charge pulses.
**Figure** 5 is a flowchart of an example process for determining a defect status of a rechargeable battery in accordance with some embodiments.
**Figure** 6 is a flowchart of an example process for determining a defect status of a rechargeable battery based at least in part on a comparison of an obtained rate of change of at least one battery parameter to an expected rate of change of the at least one battery parameter in accordance with some embodiments.
**Figures 7A-7E** depict example graphs that illustrate a comparison of various battery parameter values for battery cells having defects relative to healthy battery cells.
**Figure** 8 is a graph that illustrates different frequency regimes for electrochemical impedance spectroscopy (EIS).

### DETAILED DESCRIPTION

### Introduction

Disclosed herein are methods and systems for detecting and/or mitigating defects in rechargeable batteries. In some implementations, a defect status for a battery may be determined based on measured battery parameters. In accordance with claim 1, a defect status is determined based on a rate of change of one or more battery parameters. In some implementations, a defect status may be determined based on a comparison of measured battery parameters to expected values of the given battery parameters. In accordance with claim 1, a defect status is determined based on a comparison of rates of change of one or more battery parameters to expected rates of change of the one or more battery parameters.

Responsive to determining a defect status, in some implementations, a use pattern of the rechargeable battery may be modified. For example, modification of the use pattern may involve modifying or adapting a charging pattern, a discharge pattern, a storage pattern, a battery temperature, or any combination thereof. Modification of the use pattern may extend battery life, decrease a likelihood of a battery failure, and the like.

In many implementations, battery systems are designed or adapted to capture the necessary parameter values and monitor and/or adaptively charge a rechargeable battery or device.

### Terminology

The term "battery" as used herein refers to one or more galvanic cells (each of which stores energy electrochemically). A battery may be an individual cell and/or a plurality of cells arranged electrically in a series and/or parallel configuration. Although some technical materials describe a battery as including two or more cells, the term "battery" is not so limited in this disclosure. In some implementations, a battery is a single cell or multiple cells connected in series or parallel to provide a desired voltage or current rating. Batteries considered herein are typically rechargeable (secondary batteries) and employ an intercalation anode. Intercalation anodes include an intercalation matrix or substrate such as carbon, tin, and/or silicon that is configured to insert or intercalate ions during charge. These ions are typically alkali metal ions (e.g., lithium or sodium ions) or alkaline earth metal ions. In some cases, an anode may be a metal, such as lithium metal, which may be used in some solid-state batteries.

"Battery type" distinguishes classes or groups of batteries from one another. Among the factors that identify a battery type are (i) battery chemistry (e.g., lithium ion (Li⁺) batteries and nickel metal hydride batteries), (ii) battery format (e.g., cylindrical versus prismatic versus pouch) and size (e.g., 18650 versus AA), (iii) manufacturer identity (e.g., Samsung versus Panasonic), (iv) manufacturing process, and (v) manufacturer process implementation (e.g. lot, plant, and/or site). An example of a battery type is an 18650 format rechargeable lithium-ion battery produced by a particular manufacturer (e.g., Samsung, LG, Sony, etc.) produced in a particular lot using a particular process of the manufacturer. Any one or more of the above factors may be used to define a battery type. Further, the factors may be defined specifically. For example, lithium ion batteries may be divided into types of negative electrodes such as graphite, silicon, tin or tin oxide, or lithium metal.

A "battery element" may be a group of 1 to *N* (e.g., two, five, twenty, one hundred, one thousand, etc.) cells that are operatively coupled. For example, a battery element may be a single cell. As another example, a battery element may include multiple cells that are operatively coupled, e.g., in parallel.

A "battery pack" is a collection of two or more battery elements electrically connected to one another using series and/or parallel connections. For example, a battery pack may include a plurality of battery elements (e.g., two, five, twenty, one hundred, one thousand, etc.) battery elements coupled in series and/or in parallel. In some implementations, multiple battery elements (e.g., coupled in series) may constitute what is sometimes referred to as "a battery module," and a battery pack may in turn include one or more battery modules electrically connected (e.g., in series and/or in parallel). In some embodiments, the battery elements of a battery pack may have substantially identical characteristics such as battery chemistry, capacity, etc. However, in some embodiments, the battery elements of a battery pack may differ with respect to one or more characteristics such as battery chemistry, capacity, etc. A battery pack may include an enclosure housing the constituent batteries. A battery pack may include battery monitoring and/or management circuitry. When a battery pack is monitored, parameters associated with individual battery elements included in the battery pack may be considered in aggregate. As used herein, "aggregate," when used in connection with monitoring battery elements, refers to considering measured or derived parameters from at least a subset of the battery elements of the battery pack. In some implementations, aggregation of parameters of the battery elements may comprise ranking the battery elements, selecting one or more battery elements outside a threshold range with respect to a given parameter, combining (e.g., averaging) parameters associated with two or more battery elements of the pack, applying parameters associated with two or more battery elements of the pack to a function or model that characterizes a current status of the battery pack, or the like.

The term "defect" refers to a condition of a battery. A battery may have one or more defects that cause it to perform below normal expectations or specifications. The reduced performance may be manifest as a short cycle life, low current, low discharge voltage, low power generation, low capacity, a short circuit, and the like. In extreme situations, a defect may cause a catastrophic failure or dangerous condition such as a high temperature escalation, leakage of battery components, a fire, and/or an explosion. In some cases, a defect is due to an internal physical condition within the battery. Such defects may have to do with limitations on ion mobility within the electrolyte and/or within the anode or cathode. Defects might also have to do with unusual conditions in the SEI layer of the anode of the cell. In some cases, defects are due to metal (e.g., lithium) plating on the anode. A defect may also be caused by electrolyte depletion or deterioration. In some cases, a defect may be due to manufacturing defects in the design, structure, or materials processing of the battery at the factory (e.g., pinhole defects in the anode, cathode, or separator, or the like). It should be understood that the terms "anomaly," "abuse," or "overuse" may be used interchangeably with the word "defect."

As used herein, a "defect status" of a battery may refer to an indication of whether or not a defect is present, has been determined to be present, a defect is likely to be present, whether a defect is likely to occur in a given future time window, and/or the degree to which a defect impacts or will impact the battery's health and/or performance (e.g., the battery's state of health). A "defect status" may additionally or alternatively refer to an indication of a likelihood of a defect for a given battery, where the indication of a likelihood may be a probability of a defect, an indication that a likelihood of a defect exceeds a given defect threshold (e.g., a threshold of 50% probability, a threshold of 70% probability, a threshold of 90% probability, etc.), or the like.

"Metal plating" refers to the electrochemical deposition of metal on an electrode. The process is sometimes referred to as electroplating. In various embodiments, metal plating occurs by electrochemical reduction of metal ions on a negative electrode (anode during charge). Often metal plating occurs as a result of charging a battery in a regime where a combination of charging parameters and environmental parameters make plating favorable. For example, metallic lithium may inadvertently plate on a carbon-based or silicon-based intercalation electrode during charging of a lithium ion battery which can lead to dendrites. As another example, metallic dendrites may grow on metallic anodes.

"Use pattern" refers to a manner by which a battery is operated over time, typically over multiple cycles or multiple days, weeks, months, or years. A battery's use pattern may be divided into a charge use pattern and a discharge use pattern. Examples of features that may contribute to a battery's use pattern include charge rate, discharge rate, charge profile, and discharge profile. Further examples of battery use pattern features include depth of discharge, capacity, constant current (charge) characteristics, constant voltage (charge) characteristics, voltage and/or current cutoffs during charge, temperature profiles, and/or various environmental operating conditions. Use pattern features may be provided as an average value of any such feature, a maximum value of any such feature, a minimum value of any such feature, and the like. Such values may be determined over multiple cycles or a period of use.

"Battery Control Logic" refers to the control algorithms and/or rules that are used for determining charging parameters (for example, the amplitude, width, and frequency of charge and discharge pulses) in the charge process. In some embodiments, the algorithms or rules are chosen to improve or balance a battery's cycle life and/or charge speed. In some embodiments, the algorithms or rules are chosen to reduce, eliminate, or mitigate battery defects. Battery control logic may make use of state of health (SOH) information and/or battery feedback measurements that may include the state of charge (SOC), temperature, voltage, current, and the voltage response shape due to charging and discharging cycles. In certain embodiments, battery control logic is implemented as executable instructions or code stored in hardware (e.g., any of various forms of memory), firmware, or software. The battery control logic may also be considered to include one or more processors configured or designed to execute the instructions or code, particularly when such processors are directly linked to the memory or other storage providing the instructions or code. Unless otherwise stated, the terms battery control circuitry and control circuitry are equivalent to battery control logic.

A "charge signal" refers to the electrical current (e.g., the current waveform) that passes through the terminals of a battery as a result of circuitry configured to apply charge (a charging signal) or remove charge (a discharging signal) from a battery. A charging or recharging sequence, operation, process, or cycle may include one or more charge signals, which, in total, inject or apply charge into the battery and, optionally, one or more discharge signals (e.g., discharge signals), which, in total, remove charge from the battery. A charging signal may contain one or more charge pulses, discharge pulses and rest periods. The pulses may be any shape (for example, rectangular, triangle, sinusoidal or square). In some cases, a charge pulse has a temporal duration of between about 1 ms to about 500 ms.

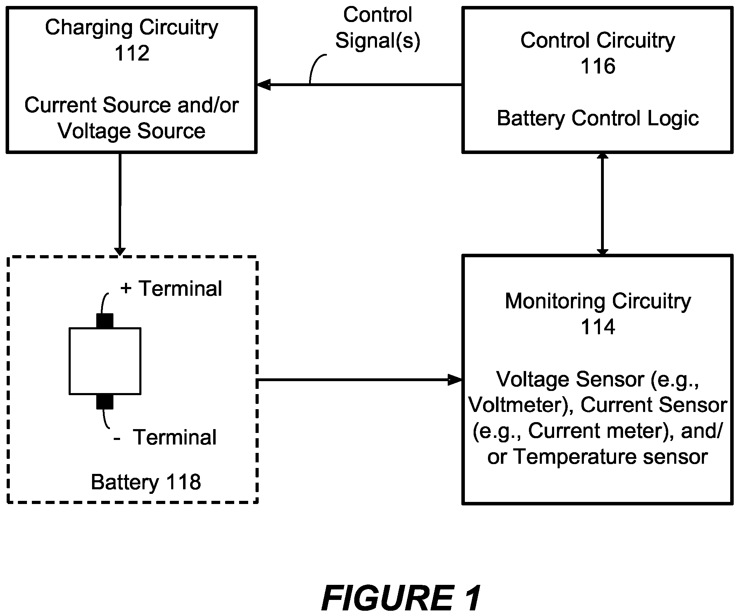

A "battery monitoring system," which may be part of a "battery charging system," is used to monitor a battery and use measured parameter values obtained from the battery (and/or characterizing conditions under which the battery is charged or otherwise operated) to determine whether the battery has plated metal. In various embodiments, the monitoring system uses a battery model to determine whether the battery has plated metal. **Figure** 1 depicts in block form a battery charging system that includes charging circuitry 112 that responds to control circuitry 116 which receives battery information from monitoring circuitry 114.

The charging circuitry 112 is configured to responsively apply electrical charge to the terminals of a battery 118 via a charge signal. The charging circuitry may include a current source and/or a voltage source to provide the charge signal.

The monitoring circuitry 114 is configured to measure, monitor, sense, detect, and/or sample (for example, on an intermittent, continuous and/or periodic basis) one or more conditions or characteristics of the battery. For example, the monitoring circuitry may measure current applied to the battery, a terminal voltage of the battery, and/or a temperature of the battery. The monitoring circuitry provides data which is representative of the condition or characteristics of the battery to control circuitry.

The control circuitry 116 (or the battery control logic), using data from monitoring circuitry 114, calculates, determines and/or assesses one or more battery parameter values which may be representative of conditions and/or states of the battery. In some cases, battery parameters are measured by the monitoring circuitry and provided as an input to a model which returns an expected state or condition of the battery. In some cases, battery control logic may determine or estimates a battery's state of charge (SOC), state of health (SOH), partial relaxation time, overpotential, or a defect status.

Using the data from the monitoring circuitry (or parameters calculated from the data provided by monitoring circuitry) the control circuitry controls (e.g., adapts or terminates) the charge signal(s) applied to a battery via a charge circuitry. For example, control circuitry may determine adopt changes in charging processes.

"Charge Process" or "charging process" refers to a process in which a battery is charged from a state of less charge to a state of more charge. During a charge process, the battery's state of charge increases. A charge process may be conducted under the control of charging circuitry which may be part of the battery control logic. In certain embodiments, charging circuitry adapts, adjusts and/or controls the amplitude, pulse width, or duty cycle of charging or discharging pulses and/or it adjusts and/or controls the conditions of a constant voltage portion of the charge process. It may perform any of these functions to control or adjust a feature of the battery such as the battery's relaxation time, rate, shape, characteristics of the decay of the terminal voltage of the battery, and propensity to plate metal. For example, as depicted in **Figure 2****,** charging circuitry may adapt, adjust and/or control the amplitude and pulse width of the discharge pulse to reduce or minimize the "overshoot" or "undershoot" of the decay of the terminal voltage of the battery. In some cases, the charging circuitry may control the maximum voltage at the terminals, and/or control the maximum state of charge of the battery.

A "charge cycle" is the process of charging a rechargeable battery and discharging it with a particular load. In some implementations, a charge cycle means charging and discharging an amount of charge that is equivalent to the battery's capacity, but not necessarily by one full charge and one full discharge. For instance, using half the charge of a fully charged battery, recharging it, and then using the same amount of charge again count as one charge cycle. The number of charge cycles to failure indicates how many times a rechargeable battery can undergo the process of complete charging and discharging until failing certain criteria. The number of charge cycles may be used to specify a battery's expected life, which may affect battery life more than the mere passage of time.

A "battery parameter" refers to a metric of the battery that may at least partly characterize the state or health of the battery. Examples of battery parameters include open circuit voltage (OCV), charge pulse voltage (CPV), EIS, temperature, capacity, an amount of stored energy, an amount of stored electrical power, a measured or estimated battery swelling, DC impedance, or the like. Battery parameters may be either directly measured (e.g., OCV, CPV, etc.) or may be indirectly estimated based on other measured parameters (e.g., an estimate of battery swelling). In some cases, a battery parameter may be applicable to a particular time point or battery state, such as a particular SOC. In some cases, a battery parameter may include derivatives with respect to time or other variables such as current.

A "directly measured battery parameter" refers to a battery parameter that is measured directly from the battery, such as an OCV, a CPV, a temperature, etc.

A "derived battery parameter" refers to a battery parameter that is determined (e.g., using a model, an algorithm, a mathematical function, etc.) from directly measured battery parameters. One example is an estimate of battery swelling. Another example is a rate of change of a particular battery parameter as a function of time, such as a rate of change in CPV as a function of time. The rate of change of a parameter may be specific to a particular SOC.

It should be understood that, in some cases, a change in a battery parameter may be inferred from adaptive changes applied by a closed loop system to keep the battery parameter within a certain range. By way of example, a closed loop system may adapt charging voltage and/or charging current to keep a particular battery parameter within a certain range. The change in the battery parameter may then be inferred based on changes applied by the closed loop system to drive the battery parameter to stay in the given range.

An "expected value" of battery parameter is a value that is expected based on a particular use pattern and/or a particular state of a battery under consideration. For example, an expected value of a battery's open circuit voltage may be an open circuit voltage expected of a battery based on that battery's current state of health, state of charge, etc. If a battery exhibits a deviation from its expected value, it may be assumed that the battery exhibits a defect or is likely to exhibit such defect. An expected value of a battery parameter may be determined using any or many possible techniques. In some embodiments, an expected value of a battery parameter is generated using a model of battery behavior. In some embodiments, an expected value of a battery parameter is generated using empirical data collected from batteries of a similar type and/or a similar state.

"Capacity" or nominal capacity refers to the total Amp-hours available when the battery is discharged at a certain discharge current (which may be specified as a C-rate) from 100 percent state-of-charge to a defined cut-off voltage. A battery's capacity may change over multiple charge cycles. In conventional batteries, it is not uncommon for the battery's capacity to decrease or "fade" over multiple cycles.

The term "capacity fade" refers to reduction of battery capacity over time or charge cycles. It may be based on a maximum of the battery capacity or other reference values of battery capacity (e.g., 85% of initial maximum capacity, capacity at specific terminal voltage, etc.)

Terminal voltage is the voltage between the battery terminals. Terminal voltage may vary with state of charge and discharge or charge current. The terminal voltage may be measured with or without current flowing through a load. In the latter case, the terminal voltage is an open circuit voltage.

"State of charge" (SOC) may refer to the fraction of the battery's current capacity that is charged. SOC may be used to characterize how far a battery in use has progressed between a fully charged state and a discharged state. State of charge may be calculated using coulombic integration to determine the change in battery capacity over time or charge cycles. In some implementations, the SOC may be a battery parameter that serves as a reference point that may be utilized from cycle-to-cycle such that other battery parameters may be compared at a fixed SOC across multiple cycles. "State of energy" (SOE) refers to the available energy of the battery at its current state. SOE may be determined based on the present SOC of the battery and the state of health (described below) of the battery. In some cases, a future SOE of the battery may be predicted. "State of power" (SOP) refers to the available power of the battery at its current state. SOP may be determined based on the present SOC of the battery and the state of health of the battery. In some cases, a future SOP of the battery may be predicted. Note that SOC, SOE, and SOP may all be considered examples of battery parameters which may be derived from measured battery parameters, determined using various models or calculations, or any combination thereof.

The "state of health" (SOH) of a battery is a parameter that characterizes the "age" of the battery and/or ability of the battery to hold charge, for example, relative to a given time in operation (for example, the initial time in operation). The SOH of a battery provides information to estimate, calculate, measure, and/or determine other battery parameters such as the ability of a battery to hold a charge. The voltage at the terminals of the battery at a given SOC changes as the SOH changes, and hence the voltage curve (voltage versus state of charge) of the battery shifts as it ages and its SOH deteriorates. The state of health parameter is further described in US Patent No. 9,121,910, issued September 1, 2015.

An "electronic device" as indicated herein refers to a device that performs any number of tasks or functions electrically and can be powered by a battery. The device may or may not physically include (e.g., enclose or attach) the battery, battery charging system, or control logic described herein. Electronic devices may be portable or fixed. Examples of electronic devices include mobile phones, digital cameras, laptops, portable speakers, battery powered vehicles, systems for storing solar and other home generated electrical energy, and power tools. In some cases, an electronic device may include a cloud server that remotely executes one or more functions, e.g., used to control battery charging.

A "battery model" or simply "model" as used herein represents or predicts battery parameters and/or a battery status (e.g., a battery state of health, a defect status, etc.) based on other battery parameters (e.g., temperature, SOC, voltage, current, etc.). In certain embodiments, a model can be used to determine expected values of a given battery parameter in order to compare measured values for a particular battery to expected values.

A model may be applicable to a particular battery type (e.g., a particular battery chemistry, cell dimensions, manufacturing batch, etc.). In some cases, a model may account for the state of health of a battery. For example, if irreversible damages to the battery cell have occurred, a model may reflect the battery's state of health.

A model may use battery parameters such as charging voltage, discharging voltage, open circuit voltage, charging current, discharging current, state of charge, and battery temperature as inputs or fixed parameters. In some cases, battery parameters may include first or second derivatives with respect to a variable such as time or current. In some cases, a model outputs a battery's terminal voltage when it receives current and charge time or state of charge as inputs. In some cases, a model outputs a battery's current when it receives terminal voltage and charge time or state of charge as inputs. A model may include lookup tables, expressions such as regression relationships, neural networks, and the like. In some cases, a model may treat the battery as a combination of one or more resistors and one or more capacitors that may be electrically connected in series, in parallel, or in a combination where some elements are in series and some are in parallel. In some cases, the battery is modeled as a two terminal device and in some cases as a three or more terminal device. A model may relate any two parameters in a linear relationship or a non-linear relationship, or in a generalized transfer function. For example, some models may treat the relationship between charge and voltage as linear, while other models treat the relationship as non-linear.

An "open circuit voltage" (OCV) is the terminal voltage of a battery when it is not under an external load. It is a property of the cell. A closed circuit voltage (CCV) is the battery terminal voltage under load (e.g., during charging of the battery). CCV is affected by OCV, but also depends on the operation of the battery. For example, during constant current charging, a CCV may be calculated as the sum of the OCV and the charging current multiplied by the resistance of the battery. During constant voltage charge, the CCV is equal to the applied voltage.

A "charge pulse voltage" (CPV) is a voltage measurement that may be taken to determine a battery parameter or (such as SOC or SOH). In some cases, a CPV measurement may be used by an adaptive charging process. A CPV may be characterized as (i) a peak voltage, measured at the terminals of the battery/cell, which is in response to a charge pulse and/or (ii) a substantial peak voltage (i.e., within 5-10% of the peak voltage), measured at the terminals of the battery/cell, which is in response to a charge pulse."Measuring," "collecting," or "capturing" a parameter as stated herein is a way of obtaining a value of the parameter. For instance, measuring the voltage of a battery can mean using an instrument such as a voltmeter to directly measure the voltage between terminals of the battery. In some contexts, it means obtaining parameter values related to raw measurements of the battery and/or deriving other information about the battery (e.g., partial relaxation, battery swelling, etc.). Raw measurements of a battery may include current, charge passed or coulombs injected into the battery, voltage, and temperature.

A "defect likelihood" refers to a probability that a defect, or a particular type of defect, may occur in the future. In some embodiments, a defect likelihood may apply to a particular time window in the future, which may be specified in time (e.g., in the next month, in the next year, etc.) or in a particular number of future charging cycles (e.g., in the next 100 charging cycles, in the next 1,000 charging cycles, etc.).

A "regime" refers to a portion of a battery use pattern, lifetime, or parameter value range. A regime may recur cycle-by-cycle or over other period tied to battery use. Examples of battery parameter value regimes include ranges of state of charge, open circuit voltage, and internal impedance. A regime may be tied to a portion of a charge process such as a constant current region of charging, a constant voltage region of charging, a particular current step of charging, etc. In some cases, a regime is tied to an internal physical or chemical state of a battery. For example, a particular ion conduction state (e.g., an ion mobility range) may define a regime.

Numeric ranges are inclusive of the numbers defining the range. It is intended that every maximum numerical limitation given throughout this specification includes every lower numerical limitation, as if such lower numerical limitations were expressly written herein. Every minimum numerical limitation given throughout this specification will include every higher numerical limitation, as if such higher numerical limitations were expressly written herein. Every numerical range given throughout this specification will include every narrower numerical range that falls within such broader numerical range, as if such narrower numerical ranges were all expressly written herein.

The headings provided herein are not intended to limit the disclosure.

Unless defined otherwise herein, all technical and scientific terms used herein have the same meaning as commonly understood by one of ordinary skill in the art. Various scientific dictionaries that include the terms included herein are well-known and available to those in the art. Although any methods and materials similar to those described herein find use in the practice or testing of the implementations disclosed herein, some methods and materials are described.

As used herein, the singular terms "a," "an," and "the" include the plural reference unless the context clearly indicates otherwise.

The logical connector "or" as used herein is inclusive unless specified otherwise. As such, condition "A or B" is satisfied by "A and B" unless specified otherwise.

### Charging Signals

Adaptive charging as described herein refers to charging processes that make use of feedback related to battery conditions, environmental conditions, user behavior, user preferences, and the like. Using adaptive charging techniques, one or more characteristics of a charge signal may be continuously or periodically adjusted or controlled while charging a battery. For example, adaptive charging may be performed to maintain battery parameter values within a selected range. For example, adaptive charging may keep a battery charge process operating in regime where little or no metal plating occurs or is likely to occur. Adaptive charging parameter values are captured and used to control or adjust a battery's charging process, typically to optimize the battery's cycle life (e.g., by reducing or preventing metal plating on the anode) and/or to optimize charge speed. Various adaptive charging techniques are described in applications assigned to Qnovo Inc. of Newark, CA. Examples of such patents include US Patent No. 8,638,070, titled "METHOD AND CIRCUITRY TO ADAPTIVELY CHARGE A BATTERY/CELL," issued January 28, 2014; US Patent No. 8,791,669, titled "METHOD AND CIRCUITRY TO ADAPTIVELY CHARGE A BATTERY/CELL," issued July 24, 2014; US Patent No. 9,121,910, titled "METHOD AND CIRCUITRY TO ADAPTIVELY CHARGE A BATTERY/CELL USING THE STATE OF HEALTH THEREOF," issued September 1, 2015; US Patent No. 9,142,994, titled "METHOD AND CIRCUITRY TO ADAPTIVELY CHARGE A BATTERY/CELL," issued September 22, 2015; US Patent No. 9,035,623, titled "MONITOR AND CONTROL CIRCUITRY FOR CHARGING A BATTERY/CELL, AND METHODS OF OPERATING SAME," issued May 19, 2015; and US Patent No. 8,907,631, titled "ADAPTIVE CHARGING TECHNIQUE AND CIRCUITRY FOR A BATTERY/CELL USING MULTIPLE CHARGING CIRCUITS AND TEMPERATURE DATE," which issued December 9, 2014.

Parameters that may be used for adaptive charging include charge pulse voltage, charge pulse voltage reference, partial relaxation time, the state of charge, and the battery's state of health. In some cases, ranges of acceptable values of each of these parameters may vary as a function of the state of charge during the charge portion of a battery cycle. The parameters values may also vary from cycle-to-cycle over the battery's life. In some cases, adaptive charging may also make use of the current charging parameters such as the current that is being applied to a battery or the terminal voltage that is applied charging circuitry. To illustrate conventional adaptive charging, **Figure 2** illustrates how a charging process can reduce or minimize the "overshoot" or "undershoot" of the decay of the terminal voltage of the battery by adjusting the amplitude and pulse width of a discharge pulse. When a charge process provides an "overshoot" of the decay of the terminal voltage of the battery relative to partial equilibrium (see discharge pulse A), the control circuitry may instruct charging circuitry to adjust the characteristics of the discharge pulse and increase the amount of charge removed by the discharge pulse. For example, by increasing the amplitude and/or pulse width of the discharge pulse the overshoot may be corrected. When a charge process results in an "undershoot" of the decay of the terminal voltage of the battery relative to partial equilibrium (see discharge pulse C), control circuitry may instruct charging circuitry to decrease the amount of charge removed by the discharge pulse (for example, via decreasing the amplitude and/or pulse width of the discharge pulse). As such, the control circuitry may adjust the characteristics of a discharge pulse (for example, the amplitude, pulse width and/or pulse shape) to control or adjust rate, shape and/or characteristics of the decay of the terminal voltage of the battery.

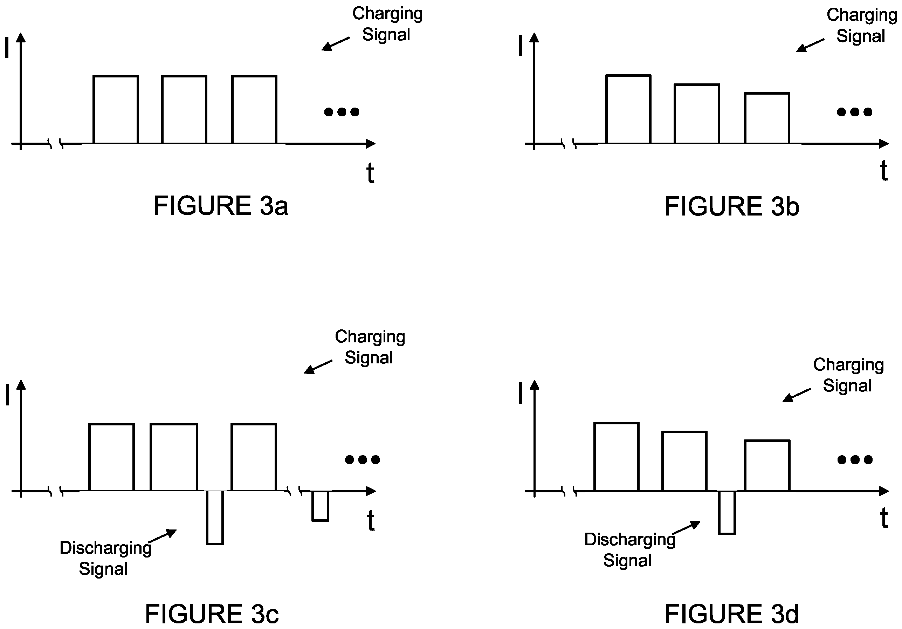

**Figures 3a-3d** illustrate waveforms of charge signals. A charging or recharging sequence, operation, or cycle may include charging signals (which, in total, inject or apply charge into the battery) and discharging signals (which, in total, remove charge from the battery). Charging signals may decrease according to a predetermined rate and/or pattern (for example, asymptotically, linearly or quadratically) as the terminal voltage of the battery increases during a charging or recharging sequence, operation, or cycle (see, e.g., **Figures 3b** and **3d**). In some cases, a pulse charging sequence or operation may include a constant voltage (CV) phase after a period of pulse charging and/or upon charging the battery/cell to a predetermined state of charge.

Note that, in some implementations, a charging sequence or a charging process may be adapted based on, e.g., detection or determination of a battery defect. For example, in some embodiments, a voltage (e.g., a maximum voltage) may be modified (e.g., lowered) during a CV phase of a charging process. As another example, in some embodiments, a current (e.g., a charging current) may be modified (e.g., lowered) during a constant current (CC) phase of a charging process. In some implementations, a defect may be detected or diagnosed during one charging cycle, and adaptations to the charging process may be implemented in either the same charging cycle and/or subsequent charging cycles. More detailed techniques for modifying charging voltage and/or charging current as part of adaptively modifying a charging process are described in U.S. Patent No. 10,389,156, filed on October 11, 2017, and in U.S. Patent No. 11,237,216, filed on August 15, 2017.

It should be understood that various pulse structures, e.g., of the types illustrated in Figures 2 and 3a-3d (or of those not illustrated herein) may be used to charge a battery and/or to determine characteristics of a battery. The pulse structures illustrated in Figures 2 and 3a-3d are examples of charge pulses and/or discharge pulses, however, other pulse shapes may be used to implement the techniques described herein.

Some or all of the characteristics of the charge and discharge pulses may be programmable and/or controllable. For example, the pulse amplitude, width/duration, and shape may be adjusted. In other examples, the amplitude of the positive and/or negative pulses may vary within the packet, the duration and/or timing of the rest periods may vary within the packet, and/or pulses may be equally or unequally spaced within the packet. The combination of charging pulses, discharging pulses and rest periods may be repetitive, thereby forming a packet that may be repeated. All combinations or permutations of pulse characteristics, periods, packets and signal characteristics and configurations are intended to fall within the scope of the present inventions.

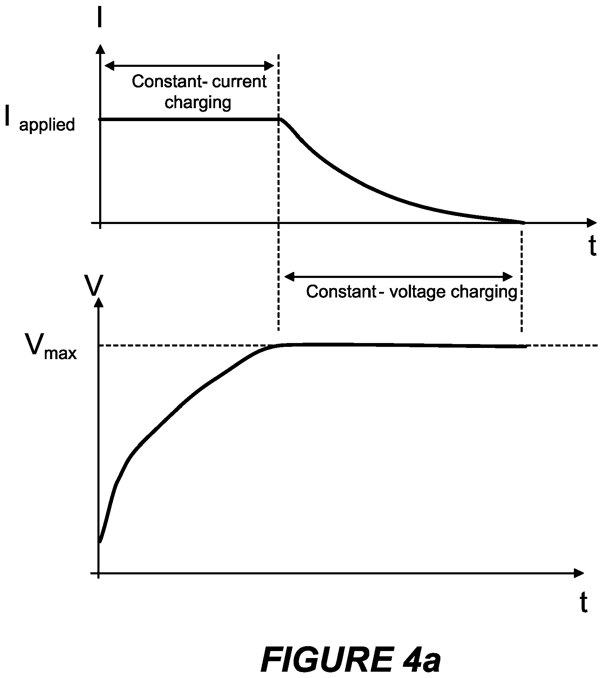

**Figure 4a** illustrates current and voltage of a battery as a function of time illustrating the conventional charging method known as constant-current, constant-voltage (CCCV). When charging a rechargeable battery (e.g., a lithium-ion type rechargeable battery) using CCCV, the charging sequence includes a constant-current (CC) charging mode until the terminal voltage of the battery/cell is at about a maximum amplitude (for example, about 4.2V to 4.5V for certain lithium-ion type rechargeable batteries) at which point the charging sequence changes from the constant-current charging mode to a constant-voltage (CV) charging mode. In the CV mode, a constant voltage is applied to the terminals of the battery. Generally when charging a rechargeable battery using the CCCV technique, the charging circuitry often changes from the CC charging mode to the CV charging mode when the state of charge (SOC) of the battery is at about 60-80%, although in some embodiments, as described herein, a charging circuitry does not enter a CV charging mode until the battery charge is greater than about 90% SOC or greater than about 95% SOC.

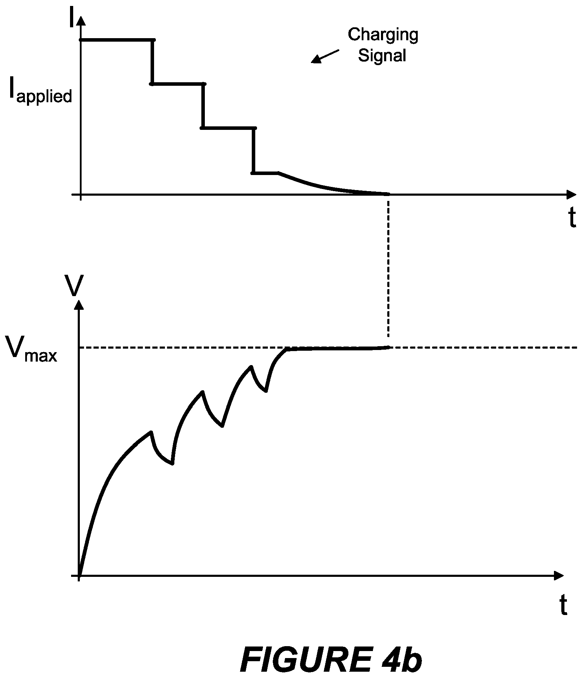

**Figure 4b** illustrates current and voltage of a battery as a function of time illustrating a charging method known as a step-charging technique. A step-charging process of a rechargeable battery (e.g., a lithium-ion type rechargeable battery), employs a multiple step constant-current (CC) charging mode until the terminal voltage of the battery is at about a maximum amplitude (for example, about 4.2V to 4.5V for certain lithium-ion type rechargeable batteries) at which point the charging sequence changes from the constant-current charging mode to a constant-voltage (CV) charging mode. As with the CCCV technique depicted in **Figure 4a****,** a constant voltage is applied to the terminals of the battery while in the CV mode.

### Detecting and Mitigating Battery Defects

In some embodiments, a defect status may be determined for a battery. The defect status may be determined by obtaining one or more battery parameters (which may be measured battery parameters and/or derived battery parameters) and determining a rate of change for at least one of the battery parameters. The rate of change of the at least one battery parameter may then be compared to an expected rate of change of the at least one battery parameter. A defect status, which may indicate that a defect has likely already occurred or is likely to occur in a future time window (e.g., in the next week, in the next month, in the next two months, etc.). Note that, as used herein, "likely" may mean having a probability greater than a threshold probability, e.g., with a probability of greater than about 50%, a probability of greater than about 70%, a probability of greater than about 90%, etc. In some implementations, based at least in part on the defect status, a use pattern of the battery, such as a manner in which the battery is charged and/or discharged, may be modified or adapted. Adapting use patterns of the battery may serve to mitigate a defect or a likely defect of the battery.

A battery defect may occur due to battery abuse, battery overuse, and/or a battery anomaly (e.g., a manufacturing anomaly). In some cases, a battery defect may indicate abnormal aging of the battery. Generally, abnormal aging may be recognized without necessarily determining the type of defect that causes the abnormal aging. Further analysis and qualification may be made to determine the type of defect that causes the abnormally aging.

Various types of defects may be detected and/or mitigated using the techniques described herein. In some cases, battery defects may result from an abnormality in one or more internal components of a battery. Such defects may arise from manufacturing anomalies or usage that can lead to limitations in ion mobility within the electrolyte, separator, and/or within the anode and cathode. Defects might also arise from a problem with the SEI layer on the anode of the battery (e.g., in cases of a non-metallic anode). Examples of manufacturing defects include: torn or folded layers, including the separator, anode, or cathode tabs; pin defects; missing electrolyte; non-uniform thickness of any structural layer; misaligned layers (e.g., anode versus cathode, anode versus separator, etc.); structural asymmetries in assembly of internal layers; distortions or mechanical stress; and mechanical fracture of grains or layers and/or structural materials. Such manufacturing defects may manifest in one or more ways, including: SEI layer fracture; non-uniform growth/re-growth; stress and mechanical fracture of material grain; loss or decomposition of electrolyte; excess current concentration leading to excess localized temperature rise and/or damage to layers; rise in electrical impedance; degradation of ionic diffusion/transport properties within the anode and/or cathode and across the layers from one electrode to another; and formation or presence of lithium metal plating in the form of thin films or non-uniform dendritic trees. In some cases, defects may arise from physical damage to the battery (e.g., a dent), environmental damage (e.g., due to high temperatures), and/or electrical damage (e.g., over-voltage). In some cases, defects may arise due to extreme temperatures (either too hot or too cold).

Various battery parameters, which are described below in more detail, may be utilized to detect battery defects. Some of these are directly measured and quantified. Such directly measured parameters may be provided in terms of a magnitude, a polarity or direction (e.g., as a positive or negative voltage or current), and/or a phase difference between signals (e.g., between current and voltage).

In some embodiments, a battery parameter may be an indirectly measured parameter that is derived from directly measured parameters. In some cases, a derived battery parameter represents a change in magnitude, phase, and/or a change in direction of any one of the directly measured parameters. In some cases, a derived battery parameter may represent a spectral change (e.g., based on electrochemical impedance spectroscopy (EIS)). For example, the rate of change of a parameter and/or the change in direction of a parameter may be a derived battery parameter.

Examples of battery parameters include: open circuit voltage (OCV); charge pulse voltage (CPV), which is often an indication of ion diffusion in the anode of the battery; EIS, which is a measure of ion diffusion in the battery materials (e.g., anode, cathode, and/or electrolyte), particularly at low frequencies and is indicative of the dynamics of charge transfer at higher frequencies; temperature; capacity; swelling of the battery (which may be measured using various techniques such as those described in US Patent No. 11,079,212 issued August 3, 2021); impedance, which may indicate the internal physical condition of a battery and which may be described in the form of complex impedance elements dependent on frequency; SOC, which may itself depend on battery voltage and/or battery health; and loaded circuit voltage (LCV) and current. Loaded circuit voltage refers to the terminal voltage of a battery when a load is connected, and may be measured at a battery cell or element level and/or at a battery pack level Note that battery parameters may be provided as either an absolute magnitude, a direction or polarity, and/or a rate of change. In some cases, each battery parameter may be measured as a function of SOC, as a function of cycle number, as a function of voltage, as a function of time, or any combination thereof.

Note that, in some embodiments, a prior pattern of using a battery may also be used, optionally along with battery parameters, in determining whether a battery defect has occurred or is likely to occur. A battery use pattern may also be used to indicate a likelihood that a defect will occur in the future if a present use pattern continues and/or if a different use pattern is adopted. A battery use pattern may be described or characterized in various ways. Examples of ways in which a battery use pattern may be characterized include: a mode of charging a battery, a mode of storing a battery, a mode of discharging the battery, and the like. Factors such charge rate, discharge rate, depth of charge, depth of discharge, temperature, storage condition, etc. may be pertinent parts of a battery's use pattern. These or other factors may be represented as an average, maximum, and/or minimum value.

By way of example, a battery use pattern during charging of the battery may be represented by: values and sequence of current and/or voltage over time that are used to charge the battery; values and sequence of current and/or voltage as a function of SOC of the battery; values and sequence of current and/or voltage as a function of temperature; values and sequence of current and/or voltage as a function of health and/or age of the battery; or any combination thereof.

As another example, a battery use pattern during discharge of the battery may be represented by values and sequence of current and/or voltage as they fluctuate over time during operation of a device powered by the battery. As a more particular example, a battery used on a mobile device to view media content may have a discharge pattern that is different from the discharge pattern of a battery used to accelerate an electric vehicle. Other examples of representations of battery use patterns during discharge of a battery include: discharge dependence on SOC; discharge dependence on temperature (e.g., whether an electric vehicle has a reduced driving range in cold weather); discharge dependence on battery health or age; and discharge dependence on battery design, materials, or manufacturing.

As yet another example, a battery use pattern as it relates to storage of the battery may be dependent on factors associated with the storage, such as whether the battery is plugged in while stored, the temperature of the storage area, whether the battery is connected to other cells in the pack, a duration of storage, or any combination thereof.

In some embodiments, a rate of change of a given battery parameter may be utilized to determine a defect status of a battery. In some implementations, the rate of change of a parameter may be with respect to a particular recurring state of a battery, such as an SOC of the battery. The recurring state may be discrete value (e.g., SOC = 50%) or it may be a bounded region of regime (e.g., SOC is between 20 and 25%). By way of example, a rate of change of an OCV at a particular SOC being greater than expected may indicate a possible defect such as lithium metal plating. As another example, a rate of change of a CPV at a given SOC being greater than expected may indicate a possible defect such as lithium metal plating. Other examples of rates of change include: a rate of change of the state of heath (SOH) of the battery; a rate of change of diffusion; and/or a rate of change of EIS impedance (e.g., real impedance and/or complex impedance) as a function of time.

In some implementations, the recurring state that is used for each reading of a particular battery parameter value may occur over successive battery cycles, assuming that a battery is cycled normally (e.g., it is fully discharged and fully charged from one cycle to the next). Sometimes, however, a battery is not fully charged or discharged but rather turned off and on while being partially charged and then partially discharged. In such cases, the concept of a battery cycle might not be represented, but nevertheless, a battery parameter of interest can be measured repeatedly; for example, each time the battery reaches a defined state (e.g., 50% SOC). As an example, a battery may be discharged from 70% to 30% and charged again repeatedly by a user or by a particular application. This may result from the user's preferences or habits and/or from a battery management protocol that limits the battery to a particular cut off charge level and/or a particular cut off discharge level. Regardless of whether recurring states of charge (for measuring a battery parameter) are encountered on a cycle-by-cycle basis and/or just in response to the battery repeatedly crossing that state of charge in a non-cyclic basis, a particular value of state of charge is repeatedly encountered over time. And regardless of how that state of charge is encountered, each time it is encountered, a battery parameter of interest may be measured so that rate of change of that battery parameter can be determined. The repeated measurements used in determining rate of change may be made over a particular window of occurrences, such as over the last X cycles and/or the last X months or weeks or other period of use.

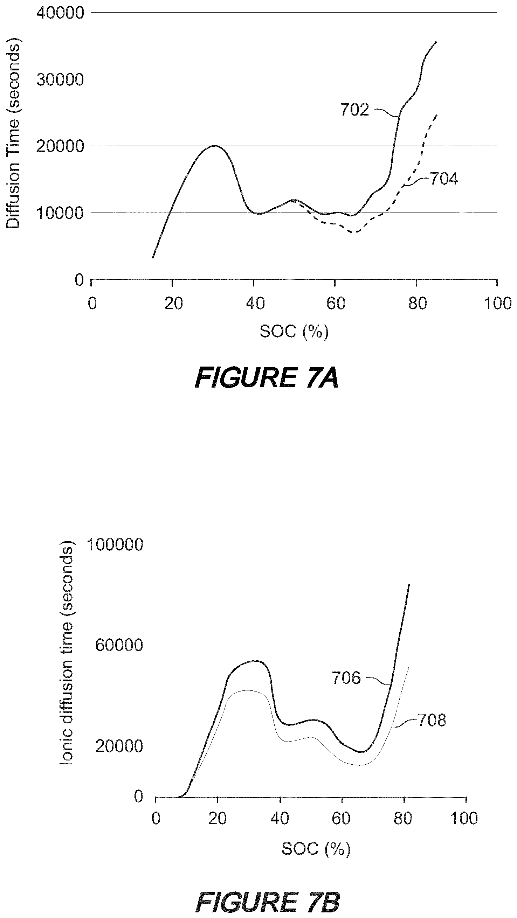

Turning to Figures 7A-7E, example graphs depicting various battery parameter measurements are illustrated in accordance with some embodiments. Figure 7A illustrates diffusion time (in seconds) as a function of SOC for a battery cell exhibiting the presence of one or more defects (e.g., lithium plating) in curve 702 and for a battery cell free of any defects (e.g., free of lithium plating) in curve 704. As illustrated, at a given SOC, a cell with one or more defects may have a higher diffusion time relative to a cell without defects, particularly at higher SOC values (e.g., above 50%, above 60%, above 70%, etc.). Figure 7B illustrates another example of diffusion time as a function of SOC for a battery cell exhibiting the presence of one or more defects (e.g., lithium plating) in curve 706 and for a battery cell free of any defects in curve 708. Note that, similar to what is shown in Figure 7A, at a given SOC, the cell with one or more defects has a higher diffusion time relative to the cell without defects.

Figures 7A and 7B illustrates ionic diffusion values, which may be influenced by ions moving within the electrolyte, across the electrolyte-electrode interface, and within the solid electrode. In some embodiments, a measured diffusion metric may be some composite of diffusion at two or more regions. The regions that contribute to a given diffusion metric may depend on a frequency at which a measurement (e.g., an EIS measurement) is made or derived. It should be noted that diffusion, e.g., ionic diffusion, may be derived from various battery parameter values. These battery parameter values may include CPV, relaxation time, partial relaxation time, EIS information, or any combination thereof. When EIS information is used, EIS data obtained from a low-frequency regime (e.g., less than about 1 Hz) may be particularly useful for determining ionic diffusion metrics. More detailed techniques relating to determination of diffusion information, as well as characterization of the underlying phenomena, are described in U.S. Patent No. 11,397,215, filed November 7, 2018.

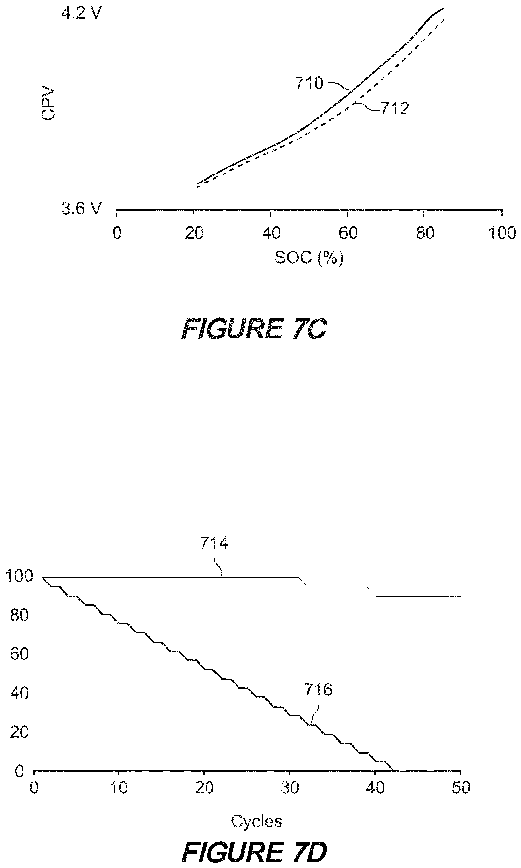

Turning to Figure 7C, a graph that illustrates CPV (in Volts) as a function of SOC is shown for a battery cell having one or more defects in curve 710 and for a battery cell free of any defects in curve 712. As illustrated, at a given SOC, a battery cell having one or more defects may have a higher CPV relative to a battery cell free of any defects. The difference in CPV for a battery cell having defects versus the expected CPV for a battery cell free of defects may be higher at relatively higher SOC values (e.g., above 50%, above 60%, etc.).

Turning to Figure 7D, a graph that illustrates a battery health index as a function of number of battery cycles is shown in accordance with some embodiments. As illustrated by curve 714, for a battery cell free of any defects the battery health index is relative stable over, e.g., 50 charging cycles. In contrast, as illustrated by curve 716, for a battery cell having one or more defects, the battery health index decreases over the multiple charging cycles.

Battery health index may be a metric that is normalized (e.g., to a value between 0 and 100 as shown in Figure 7D). The battery health index may be a composite score that is determined based on multiple battery parameter values, such as CPV, diffusion time, partial relaxation time, full relaxation time, DC impedance, EIS quantities (e.g., real impedance and/or complex impedance), temperature, capacity, or any combination thereof. In some implementations, the battery health index may be determined using a mathematical function or a model (e.g., a regression model, or the like), that takes, as inputs, one or more battery parameters (e.g., one, two, three, five, etc. battery parameters) and generates the battery health index as an output. In some embodiments, the battery health index may be determined by employing a function that takes, as inputs, one or more battery parameters and determines the battery health index as an output. The function may be a weighted sum, an exponential function, a polynomial function, utilize the output of a machine learning model, or the like. In one example, a battery health index may be determined as a combination of CPV and diffusion information. In another example, a battery health index may be determined based on high frequency impedance information, which may include real and/or imaginary impedances. In yet another example, in some implementations, a battery health index may be determined based on DC impedance. In some implementations, one or more battery parameter values used to determine a battery health index may be proxy values for a given battery parameter. A proxy value may be a value of a surrogate parameter that is varied to keep a different battery parameter within a given range (or above or below a given threshold) in a closed-loop system during charging and/or discharging. By way of example, current may be modified (e.g., during charging of a battery) to control a DC impedance or an EIS characteristics of the battery, e.g., to force the DC impedance and/or the EIS characteristics to remain within a given range or above or below a predetermined threshold. Continuing with this example, the current values used to control the DC impedance and/or the EIS characteristics may be considered a proxy value, and may in turn by used to determine the battery health index.

Note that, as illustrated in Figure 7D, for a battery cell exhibiting one or more defects, the battery health index may decrease in a substantially linear manner as a function of cycle number. However, in other cases, the decrease in the battery health index may have any other shape, such as a substantially exponential decrease, or the like. As illustrated in Figure 7D, the change in battery health index may have a piecewise shape, as the battery health index may be measured and/or characterized as a function of cycle number. It should be understood that, in some cases, a battery health index score may characterize a health of the battery in a manner that provides more granular and/or predictive information relative to other battery parameters, such as battery capacity. By way of example, in some cases, a battery's capacity may be determined to be substantially normal or as expected for a given type of battery and/or for a battery having a given age, however, the battery health index may be lower than expected. This may indicate degradation in the battery that is not yet visible in the battery capacity metric.

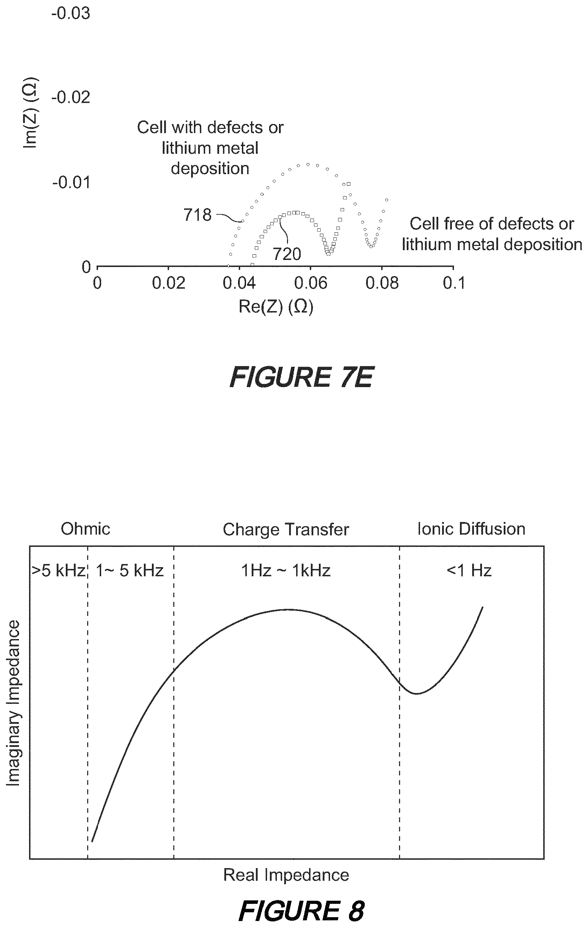

Turning to Figure 7E, a graph that illustrates EIS measurements for a battery cell with defects and without defects is shown in accordance with some implementations. In particular, the graph shown in Figure 7E illustrates imaginary impedance as a function of real impedance for a battery cell with defects in curve 718, and for a battery cell without defects in curve 720. It should be noted EIS measurements may be made in either the time domain or the frequency domain. For example, the EIS measurements depicted in Figure 7E are represented in the frequency domain, where each point represents a different frequency. However, in some cases, EIS measurements may be taken in the time domain (e.g., with different points corresponding to different time points), and may subsequently be converted to the frequency domain. Referring to Figure 8, different frequency bands with respect to EIS represent diffusion at different scales. For example, the high frequency range (e.g., greater than about 1 kHz) represents the ohmic regime. As another example, a middle frequency range (e.g., within a range of about 1 Hz to 1 kHz) represents the charge transfer regime, as illustrated in Figure 8. A low frequency range (e.g., less than about 1 Hz) represents the ionic diffusion regime. The ionic diffusion regime represents diffusion of ions throughout the battery (e.g., from cathode to anode), and represents an average of different types of diffusion (e.g., electrolytic diffusion, solid state diffusion, etc.), as illustrated in Figure 8.

It should be noted that various battery parameters may be derived from EIS measurements. For example, diffusion time, as shown in Figure 7A, may be derived from EIS measurements. In particular, in some cases, a diffusion time may be calculated using a slope of the EIS measurements within the low frequency range (e.g., from points on the right most side of the EIS graph shown in Figure 7E, corresponding to frequencies less than about 1 Hz). CPV is another example of a battery parameter that may be derived from EIS measurements.

The graphs depicted in Figures 7A-7E illustrate comparisons of a given battery parameter for a battery cell having one or more defects versus the expected value of the given battery parameter (e.g., for a battery cell without any defects). In some implementations, comparisons of a measured battery parameter value to an expected battery parameter value may be utilized to detect or identify defects. Additionally or alternatively, in some implementations, a rate of change of a given battery parameter may be utilized. It should be noted that, in some cases, an absolute value of a particular parameter may indicate present battery health, whereas a rate of change of the same parameter may indicate future safety of the battery. In some cases, rate of change of a particular parameter may be compared at different SOCs. For example, at a first SOC (e.g., 40%), the rate of change of a parameter may be X, whereas at a second SOC (e.g., 70%), the rate of change of the same parameter may be a different value Y. For a particular parameter, predictive accuracy may be dependent on the SOC. In other words, some SOCs may be more sensitive than other SOCs. In some cases, a rate of change of a particular parameter may be compared at other battery states, such as at a particular value or range of: terminal voltage or voltage range, cycle number, temperature, frequency of measurement (e.g., in the case of EIS measurements), or any combination thereof.

In some implementations, responsive to determining a defect status for a given rechargeable battery as that a defect is likely present or is likely to occur, the use pattern of the battery may be adapted or modified. For example, such use patterns may apply to charging of the battery and/or discharging of the battery. In some cases, a temperature of the battery may be modified (e.g., increased or decreased). In some cases, the modification to the use pattern (e.g., a modification to a charging pattern, a modification to a discharge pattern, a change in battery temperature) may be applicable to a particular regime, such as a particular SOC or SOC range.

Examples of adaptations that may be implemented during charging of a battery include: modifying (e.g., reducing) a current and/or voltage (e.g., when a particular parameter value for SOC, time point, temperature, CPV, relaxation time, SOH, etc. has been reached), ending charging prior to 100% SOC being reached (or prior to the equivalent maximum voltage being reached), modifying a duty cycle or frequency of charge pulses or packets, modifying a charging power (e.g., at a given SOC), reversing (e.g., occasionally reversing) a polarity at a given SOC or responsive to detecting a particular type of defect (e.g., lithium plating), modifying a charging rate, modifying a depth of charge, intermittent pausing of charging at a particular SOC, CPV, and/or temperature, or any combination thereof. Note that when charging is paused, the pause may be within a time range of anywhere from a few milliseconds to tens of seconds. The duration of the pause may be dependent on measured or derived battery parameters.

Examples of adaptations that may be implemented during discharge of a battery include: modifying a maximum discharge current magnitude (e.g., at a given SOC, temperature, or other parameter); modifying a discharge rate, limiting the depth of discharge (e.g., the difference between the minimum and maximum SOC or the minimum and maximum voltage); limiting a maximum power output; limiting a maximum temperature rise; or any combination thereof. Further discussion of suitable adaptations is presented herein and in other patent applications in the context of "adaptive charging." See for example US Patent No. 11,397,215 and US Patent 11,397,216.

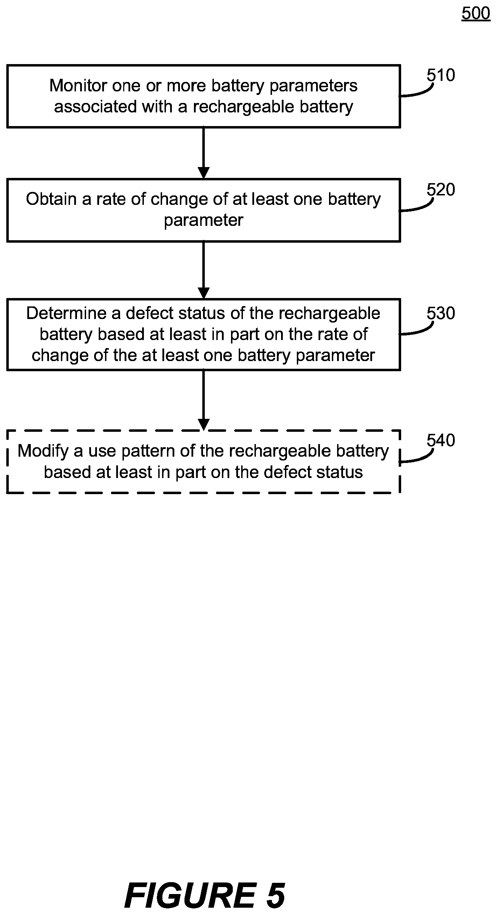

**Figure** 5 illustrates a flowchart of an example process 500 for detecting a defect status based on obtained battery parameters. Blocks of process 500 may be performed on battery monitoring circuitry and/or battery control circuitry. In some embodiments, such circuitry may be local to and/or proximate to the battery. Alternatively, in some embodiments, such circuitry, or portions of the circuitry, may be remote, e.g., in a cloud device or remote server. For example, in some embodiments, determination of a defect status may be performed at a remote device. It should be noted that blocks of process 500 may be performed in an order other than what is shown in Figure 5. In some implementations, two or more blocks of process 500 may be performed substantially in parallel. In some embodiments, one or more blocks of process 500 may be omitted.

At 510, process 500 can begin by monitoring one or more battery parameters associated with a rechargeable battery. Examples of such battery parameters are described above in more detail. Note that the battery parameters may include directly measured battery parameters, derived battery parameters (e.g., parameters derived based on measured battery parameters), or any combination thereof.

At 520, process 500 can obtain a rate of change of at least one battery parameter. The rate of change may be obtained with respect to time, which may be represented as absolute time, charging cycle number, or the like. In some implementations, the rate of change of the at least one battery parameter may be determined in connection with a determination of a present regime the rechargeable battery is operating in. As described above in more detail, the regime may indicate the present SOC of the battery (or an SOC range the battery is in), a present temperature of the battery (or a temperature range the battery is in), etc. It should be noted that, in some implementations, the rate of change may span multiple (e.g., more than two, more than five, more than ten, more than twenty, etc.) cycles of the rechargeable battery. In some implementations, each measurement over multiple cycles is made with respect to the same or a similar reference point such as the same SOC or SOE during each cycle.

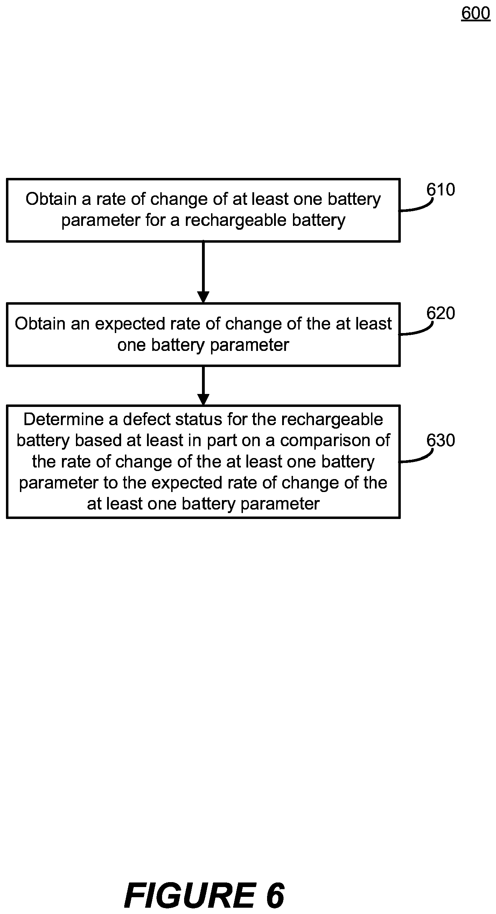

At 530, process 500 can determine a defect status of the rechargeable battery based at least part on the rate of change of the at least one battery parameter. For example, in some embodiments, process 500 can compare the rate of change of the at least one battery parameter to an expected rate of change of the at least one battery parameter. As a more particular example, as described above, a rate of change of an OCV and/or a CPV at certain SOCs that are larger than expected rates of change may be indicative of lithium metal plating. Note that more detailed techniques for determining expected rates of change are described below in more detail (e.g., in connection with Figure 6).

At 540, process 500 optionally modifies a use pattern of the rechargeable battery based at least in part on the defect status. For example, in some implementations, process 500 can determine the use pattern is to be modified responsive to the defect status indicating that a likelihood of the rechargeable battery having a defect at a present time is greater than a predetermined threshold (e.g., a probability of 50%, a probability of 70%, a probability of 90%, etc.). As another example, in some implementations, process 600 can determine the use pattern is to be modified responsive to the defect status indicating that a likelihood of the rechargeable battery having a defect within a future time window (e.g., the next week, the next month, etc.) is greater than a predetermined threshold (e.g., a probability of 50%, a probability of 70%, a probability of 90%, etc.).

As described above, modification of the use pattern may involve modification of a charging pattern, modification of a discharge pattern, and/or modification of a temperature of the battery. Examples of modifications of the charging pattern and/or modifications of the discharge pattern are described above in more detail. Note that, in some implementations, a modified use pattern may be identified based on stored use patterns. For example, a modified use pattern may be selected from a set of use patterns based, e.g., on the defect status. In some implementations, a given modified use pattern may be applicable at a given SOC or for a given SOC range. In some embodiments, a modified use pattern may be implemented as an adaptive charging procedure.

In some implementations, process 500 may loop back to 510 and may continue monitoring the battery. In some implementations, process 500 may continually loop through blocks 510-540 throughout the life of the rechargeable battery and may adaptively modify battery use patterns responsive to updated defect status information.

In some implementations, a battery parameter (or a rate of change of the battery parameter) may be compared to an expected value of the given battery parameter (or the expected rate of change of the battery parameter). An expected value or an expected rate of change for a given battery parameter may be provided by any of various sources such as a model of the expected value, a history of battery parameter values from batteries known to be defective or normal (i.e., empirically derived values of battery parameters), and/or statistical methods or machine learning methods. In cases in which statistics methods or machine learning methods are used, the statistics methods and/or machine learning models may be applied to field data, aggregated data sets, or the like.

A model which is configured to provide or generate expected values of battery parameters or expected rates of change of battery parameters may have various architectures. For example, a model may be based on an equivalent circuit of a battery, such as an RLC circuit model. As another example, a model may be a machine learning model. In some implementations, such a machine learning model may have been trained using measured battery parameter values and tags that classify the battery as normal, abnormal, or as having a particular type of abnormality such as a type of defect (such as lithium metal plating, abruptly decaying capacity, increase in impedance, swelling, changes in cycle life, or any combination thereof. As yet another example, a model may be derived from statistical analysis applied to, e.g., field data or aggregated data sets. Such field data or aggregated data sets may be associated with batteries from a particular manufacturer, batteries having a particular model type, etc. As still another examples, a model may be based on a mathematical expression representing data measured for the battery under consideration or multiple other batteries of the same or similar type as a battery under consideration. The mathematical expression may be a polynomial, linear, non-linear, or discrete representation of the data that has been collected. As still another example, a model may be an iterative computational method, e.g., which may serve to optimize a quantity such as cycle life or charge time.

It should be noted that a model used to generate an expected value of a battery parameter and/or an expected rate of change of a battery parameter may be valid for a specific type of battery (e.g., a battery within one lot produced by single vendor). Alternatively, a model may be valid for multiple different types of battery. However, in many cases, a model is valid for only one battery chemistry, such as lithium ion chemistry, or structural design.

Additionally, it should be noted that a given model may represent expected battery parameter values for only a particular regime of a battery's use pattern. For example, a given model may be associated with measured battery parameter values at (a) a defined range of states of charge, (b) a constant current portion of a battery charging protocol, or (c) a constant voltage portion of a battery charging protocol. Additionally, in some embodiments, a model may be constructed as a concatenation of sub-models. Each sub-model may be valid over a particular range of a parameter (e.g., SOC, temperature, voltage, or the like) such that the aggregate model is valid over the full range of the parameter.

In some embodiments, a defect status may be determined by comparing obtained battery parameters (e.g., measured battery parameters and/or derived battery parameter which have been derived from measured battery parameters) to expected values of the given battery parameter(s). Note that the comparison may be applied to a measured rate of change of a battery parameter compared to the expected rate of change of the given battery parameter. The comparison may be made within a particular regime (e.g., SOC, temperature, etc.) of battery operation or use.

In some implementations, a comparison of measured parameter values to expected parameter values may indicate whether there is a deviation or difference between the measured and the expected values. The difference (e.g., the magnitude of the difference between the measured an expected values) is quantified or qualified and used to determine whether a defect has occurred, a probability that a defect is to occur, or whether some other condition that deserves attention has occurred. This determination may be employed in a decision of whether to adjust a use pattern of the battery.

Figure 6 illustrates a flowchart of an example process 600 for detecting a defect status based on a comparison of measured battery parameter values to expected battery parameter values. Blocks of process 600 may be performed on battery monitoring circuitry and/or battery control circuitry. In some embodiments, such circuitry may be local to and/or proximate to the battery. Alternatively, in some embodiments, such circuitry, or portions of the circuitry, may be remote, e.g., in a cloud device or remote server. For example, in some embodiments, determination of a defect status may be performed at a remote device. It should be noted that blocks of process 600 may be performed in an order other than what is shown in Figure 6. In some implementations, two or more blocks of process 700 may be performed substantially in parallel. In some embodiments, one or more blocks of process 700 may be omitted.

Process 600 can begin at 610 by obtaining a rate of change of at least one battery parameter for a rechargeable battery. As described above in connection with Figure 5, the rate of change may be obtained with respect to time, which may be represented as absolute time, charging cycle number, or the like. In some implementations, the rate of change of the at least one battery parameter may be determined in connection with a determination of a present regime the rechargeable battery is operating in. As described above in more detail, the regime may indicate the present SOC of the battery (or an SOC range the battery is in), a present temperature of the battery (or a temperature range the battery is in), etc. It should be noted that, in some implementations, the rate of change may span multiple (e.g., more than two, more than five, more than ten, more than twenty, etc.) cycles of the rechargeable battery.

At 620, process 600 can obtain an expected rate of change of the at least one battery parameter. In some implementations, the expected rate of change may be obtained from a model. As described above, the model may be a numerical computational model, a machine learning model, based on an equivalent circuit model of the rechargeable battery, one or more mathematical expressions or equations, or any combination thereof. In some implementations, a model may be derived based on a statistical analysis of data (e.g., field test data, data from a database, historical data, or the like). In instances in which a machine learning model is used, the model may be trained using any suitable data, such as field test data, data from a database, historical data, etc. Additionally, or alternatively, in some implementations, the machine learning model may be trained from data obtained from a second model (e.g., a numeric simulation model, a model based on an equivalent circuit, etc.). As described above, the model may be specific to a particular type of battery (e.g., a battery using a specific chemistry, a battery having particular dimensions or specifications, a battery made by a particular manufacturer, a battery from a particular lot, etc.), or may be more generally applicable. The model and/or the expected rate of change of the at least one battery parameter may be specific to a given regime (e.g., a particular SOC or range of SOCs, a particular temperature or range of temperatures, etc.).

At 630, process 600 can determine a defect status for the rechargeable battery based at least in part on a comparison of the rate of change of the at least one battery parameter to the expected rate of change of the at least one battery parameter. For example, process 700 can determine that a defect is likely present, or is likely to occur in a future time window, responsive to determining that a deviation between the rate of change of the at least one battery parameter and the expected rate of change of the at least one battery parameter exceeds a predetermined threshold. Note that, in some implementations, a defect status may be determined based on comparisons of multiple (e.g., two, three, five, ten, etc.) battery parameters. In such instances, the defect status may be determined by aggregating differences between the measured battery parameters (or rates of change of the battery parameters) to expected values of the battery parameters (or expected rates of change), for example, by performing an average or a weighted average. In some implementations, there may be a different threshold for each battery parameter to flag a likely defect.

### Apparatus

The battery charging system may have many configurations. In some cases, all or most of the measured battery parameter values (e.g., current, voltage, and temperature) are collected by a single module or circuit, while in other cases, the parameter values are collected by multiple modules and/or circuits. Battery monitoring circuits and/or charging circuits may be used for this purpose. In some cases, the battery control logic, whether operating alone or in conjunction with battery monitoring and/or charging circuitry, may be used to collect the parameter values. In certain embodiments, the parameter values are collected by a module, circuit, or logic that is directly connected to a battery such as a circuit or a module that is physically attached to, mounted on, or encased in an electronic device housing the battery. In other embodiments, the parameter values are collected by a module, circuit, or logic that is distant from the battery and/or the electronic device powered by the battery. For example, the module, circuit, or logic may be coupled to the battery and/or device by a wired or wireless link.

The apparatus that operates the battery control logic may be the same apparatus used to collect the battery parameter values or may be a distinct apparatus such as a mobile device, a server, or a distributed collection of remote processing devices. In some implementations, a cloud-based application is used to store and operate the battery control logic. In certain embodiments, the apparatus used to collect battery use parameters is also used to adaptively charge a battery.

**Figure** 1 depicts in block form a battery monitoring/charging system that may be configured to prevent or reduce defects by adaptively charging a battery. The apparatus includes charging circuitry 112 that responds to control signals to generate a charge signal that is applied to the terminals of the battery. The apparatus also includes measurement circuitry 114 coupled to the battery, to measure voltage, current, and/or other battery parameter values that may be used for adaptive charging. Control circuitry 116 is coupled to the charging circuitry and the measuring circuitry. Using data received by the monitoring circuitry the control circuitry is configured to generate one or more control signals to adapt one or more characteristics of a charging signal and/or discharging signal in the context of adaptive charging. In some cases, the control circuitry may also play roles in monitoring battery performance and collecting battery parameter values.

### Charge Circuitry

**In** one embodiment, charging circuitry 112 applies one or more charge signals to the battery in response to control circuitry. The charge signals applied by the charging circuitry may include one or more charging signals which provide a net input of charge or current into the battery (see, for example, **Figures 3a** and **3b****)** and one or more discharging signals which provide a net removal of charge or current from the battery(see, for example, **Figures 3c** and 3d).

The adaptive charging circuitry and techniques may employ any charging circuitry, whether described herein, now known or later developed, to charge the battery; all such charging circuitry are intended to fall within the scope of this disclosure. For example, charging circuitry may generate charge and discharge signals, packets, and pulses (as described herein). Notably, charging circuitry is generally responsive to control signals from the control circuitry.

Discharge signals remove charge from the battery and may be employed to reduce the time period for the battery terminal voltage to return to equilibrium. In this regard, the discharge period may remove excess charge that might otherwise contribute to degradation mechanisms such as the thickening of the solid-electrolyte interface (SEI) layer or metallic plating of lithium. Clearly, the difference between the electrical charge added to the cell during a charging period and the electrical charge removed from the cell during a discharge period determines a net total electrical charge added to the cell in one period. This net total electrical charge divided by the period may determine a net effective charging current. All combination or permutations of charge signals are provided by the charge circuitry and are intended to fall within the scope of the present disclosure.

### Monitoring Circuitry

Monitoring circuitry **114** measures, monitors, senses, detects and/or samples, on a continuous or periodic basis (e.g., at predetermined states of charged) one or more conditions or characteristics of the battery. For example, the monitoring circuitry may measure the terminal voltage (an open circuit voltage (OCV) or a closed circuit voltage (CCV)), the voltage response of the battery to one or more charge pulses, and/or temperature of the battery. In one embodiment, the monitoring circuitry includes a sensor to determine a voltage (for example, a voltmeter) and/or a sensor to determine a current (for example, a current meter). The monitoring circuitry provides data which is representative of the condition or characteristics of the battery to the control circuitry. Moreover, the monitoring circuitry may include one or more temperature sensors which are thermally coupled to the battery to generate, measure, and/or provide data which is representative of the temperature of the battery. The monitoring circuitry and techniques may be those described herein, now known or later developed, to acquire data employed by the control circuitry to adapt the charging profile of the battery; all such monitoring circuitry and techniques are intended to fall within the scope of this disclosure.

### Control Circuitry

In certain embodiments, the control circuitry **116,** using data from monitoring circuitry, calculates, determines and/or assesses the state or condition of the battery in connection with the charging or recharging process. For example, control circuitry may calculate, determine and/or estimate a change in terminal voltage of the battery in response to charge or current applied to or injected into the battery. The control circuitry may also calculate, determine and/or estimate one, some, or all of the SOC of the battery, SOH of the battery, partial relaxation time of the battery and/or overpotential or full relaxation time of the battery.

The control circuitry may also calculate, determine, and/or implement a charging sequence or charging profile based on or using one or more of the adaptive charging techniques and algorithms. For example, the control circuitry may be configured to implement any of the charge or discharge adjustments described herein to address defects or potential defects. In this regard, control circuitry adapts, adjusts and/or controls one or more characteristics of the charge or current applied to or injected into the battery (via controlling the operation of charging circuitry) so that the terminal voltage, the change in terminal voltage, or another battery parameter (in response to charge or current applied to or injected into the battery during a charging or recharging sequence/operation) is within a predetermined range and/or below a predetermined value. In this regard, one or more characteristics of the charge signal may be adapted to control and/or manage battery parameters such as the terminal voltage, or a relaxation time. In addition to adapting the sequence of charge signals, discharge signals and rest periods - in relation to each other - the control circuitry may vary, adjust and/or control one or more of the variable characteristics of a charge signal. In some cases, the control circuitry may configured to obtain or provide a desired or predetermined relaxation time or period (for example, a relaxation time that is within prescribed range), by adjusting and/or controlling the amount of electrical charge removed during a discharge period, the amount of electrical charge added during a charge period, and/or the characteristics of a rest period. In one embodiment, the adaptive charging technique or algorithm employs a sequence of discharge signals where the relaxation time is calculated, determined and/or measured after each of the discharge signals. In this way, the control circuitry may adaptively determine the total amount of electrical charge that should be removed (and, in response thereto, control the charging circuitry accordingly).

There are numerous permutations involving the amount of electrical charge added to the battery during the charge signal and the amount of charge removed during the discharge signal. All permutations are intended to fall within the scope of the present disclosure. Notably, each permutation may result in a different relaxation period. Moreover, within each permutation, there exists a large number of sub-permutations that i) combine the characteristics of a charge signals (for example, the duration, shape and/or amplitude of the charge signal), the product of which determines the amount of electrical charge added to the cell; and ii) combine the characteristics of a discharge signal (for example, the duration, shape and/or amplitude of a discharge signal), the product of which determines the amount of electrical charge removed from the cell; and iii) the length of time of the rest period. The characteristics of a charge signals may differ from the characteristics of a discharge signals. That is, one or more of the duration, shape and/or amplitude of the charge signal may differ from one or more of the duration, shape and/or amplitude of the discharge signal.

Notably, control circuitry may include one or more processors, one or more state machines, one or more gate arrays, programmable gate arrays and/or field programmable gate arrays, and/or a combination thereof. Indeed, control circuitry and monitoring circuitry may share circuitry with each other as well as with other elements; such circuitry may be distributed among a plurality of integrated circuits which may also perform one or more other operations, which may be separate and distinct from that described herein. In some embodiments, control circuitry may be housed within a device containing the battery. Alternatively, a battery may be housed in an electronic device, while control circuitry may be housed elsewhere. For example, control circuitry may operate on a remote server or a cloud-based application. In some cases, control circuitry may be coupled to monitoring circuitry and/or charging circuitry via wireless or wired communication. In some cases, control circuitry may be configured to store identified parameter values on a remote server, and in some cases, control circuitry algorithms may be updated by a user.

Control circuitry may perform or execute one or more applications, routines, programs and/or data structures that implement particular methods, techniques, tasks or operations described and illustrated herein. The functionality of the applications, routines or programs may be combined or distributed. In addition, the applications, routines or programs may be implementing by control circuitry using any programming language whether now known or later developed, including, for example, assembly, FORTRAN, C, C++, and BASIC, whether compiled or uncompiled code; all of which are intended to fall within the scope of the present disclosure.

## Claims

1. A method (500) of diagnosing battery defects, the method comprising:
monitoring one or more battery parameters associated with a rechargeable battery (510);
obtaining a rate of change of at least one battery parameter of the one or more battery parameters (520); and
determining a defect status of the rechargeable battery based at least in part on the rate of change of the at least one battery parameter (530),
wherein determining the defect status of the rechargeable battery comprises comparing the rate of change of the at least one battery parameter to an expected rate of change of the at least one battery parameter, and
wherein the comparing occurs at a predetermined state of charge, SOC, or range of SOCs and/or that the expected rate of change of the at least one battery parameter is based at least in part on an output of a battery model and/or historical data from other rechargeable batteries.

2. The method of claim 1, wherein the obtained rate of change occurs over at least 2 cycles of the rechargeable battery.

3. The method of either of claims 1 or 2, wherein the battery model comprises one or more of: an equivalent circuit model of the rechargeable battery; a machine learning model; or a mathematical expression and/or wherein the battery model is specific to a type of battery corresponding to the rechargeable battery, optionally wherein the type of battery corresponds to at least one of: a battery chemistry associated with the rechargeable battery; a vendor of the rechargeable battery, or a cell design associated with the rechargeable battery.

4. The method of any one of claims 1-3, wherein the battery model is applicable to a particular regime of use of the rechargeable battery.

5. The method of claim 4, wherein the regime of use comprises at least one of: a range of SOCs, a constant current portion of a charging protocol; or a constant voltage portion of the charging protocol and/or wherein the regime of use comprises at least a portion of a discharging protocol.

6. The method of any one of claims 1-5, wherein determining the defect status of the rechargeable battery comprises considering a previous use pattern of the rechargeable battery, optionally wherein the previous use pattern comprises at least one of: a temperature of the rechargeable battery; storage conditions of the rechargeable battery; charging patterns of the rechargeable battery; discharge patterns of the rechargeable battery; or a number of charging cycles of the rechargeable battery, further optionally wherein the charging patterns comprise at least one of a charge rate or a depth of charge or wherein the discharge patterns comprise at least one of a discharge rate or a depth of discharge.

7. The method of any one of claims 1-6, wherein the one or more battery parameters comprise at least one of: an open circuit voltage of the rechargeable battery, a loaded circuit voltage of the rechargeable battery, a charge pulse voltage of the rechargeable battery, electrochemical impedance spectroscopy (EIS) information associated with the rechargeable battery, a capacity of the rechargeable battery, impedance information associated with the rechargeable battery, or a current associated with the rechargeable battery.

8. The method of any one of claims 1-7, further comprising modifying a use pattern of the rechargeable battery based at least in part on the determined defect status of the rechargeable battery (540).

9. The method of claim 8, wherein modifying the use pattern comprises at least one of: modifying a charging process used to charge the rechargeable battery; modifying a discharge process used in discharging the rechargeable battery; or modifying a temperature of the rechargeable battery, optionally wherein modifying the charging process comprises temporarily prohibiting charging of the rechargeable battery or wherein modifying the charging process comprises reducing a charging voltage and/or a charging current.

10. The method of claim 8 or 9, wherein the modified use pattern is applicable to a given SOC of the rechargeable battery or a range of SOCs of the rechargeable battery.

11. An apparatus for diagnosing battery defects, comprising:
monitoring circuitry (114), coupled to the rechargeable battery (118), configured to monitor one or more battery parameters associated with the rechargeable battery; and
control circuitry (116), coupled to the monitoring circuitry, wherein the apparatus is configured to carry out the method according to any one of claims 1-10.

## Patentansprüche

1. Verfahren (500) zum Diagnostizieren von Akkudefekten, wobei das Verfahren Folgendes umfasst:
Überwachen eines oder mehrerer Akkuparameter, die mit einem wiederaufladbaren Akku verknüpft sind (510);
Erhalten einer Änderungsrate mindestens eines Akkuparameters des einen oder der mehreren Akkuparameter (520); und
Bestimmen eines Defektstatus des wiederaufladbaren Akkus mindestens teilweise basierend auf der Änderungsrate des mindestens einen Akkuparameters (530),
wobei das Bestimmen des Defektstatus des wiederaufladbaren Akkus ein Vergleichen der Änderungsrate des mindestens einen Akkuarameters mit einer erwarteten Änderungsrate des mindestens einen Akkuparameters umfasst, und
wobei das Vergleichen bei einem vorbestimmten Ladezustand, SOC, oder einem Bereich von SOCs erfolgt und/oder die erwartete Änderungsrate des mindestens einen Akkuparameters mindestens teilweise auf einer Ausgabe eines Akkumodells und/oder historischen Daten von anderen wiederaufladbaren Akkus basiert.

2. Verfahren nach Anspruch 1, wobei die erhaltene Änderungsrate über mindestens 2 Zyklen des wiederaufladbaren Akkus erfolgt.

3. Verfahren nach einem der Ansprüche 1 oder 2, wobei das Akkumodell eines oder mehrere von Folgenden umfasst: ein Ersatzschaltungsmodell des wiederaufladbaren Akkus; ein Maschinenlernmodell; oder einen mathematischen Ausdruck und/oder wobei das Akkumodell spezifisch für einen Akkutyp ist, der dem wiederaufladbaren Akku entspricht, wobei der Akkutyp optional mindestens einem von Folgenden entspricht: einer Akkuchemie, die mit dem wiederaufladbaren Akku verknüpft ist; einem Anbieter des wiederaufladbaren Akkus oder einem Zellendesign, das mit dem wiederaufladbaren Akku verknüpft ist.

4. Verfahren nach einem der Ansprüche 1 bis 3, wobei das Akkumodell auf ein bestimmtes Nutzungsregime des wiederaufladbaren Akkus anwendbar ist.

5. Verfahren nach Anspruch 4, wobei das Nutzungsregime mindestens eines von Folgenden umfasst: einen Bereich von SOCs, einen Konstantstromanteil eines Ladeprotokolls; oder
einen Konstantspannungsanteil des Ladeprotokolls und/oder wobei das Nutzungsregime mindestens einen Anteil eines Entladeprotokolls umfasst.

6. Verfahren nach einem der Ansprüche 1 bis 5, wobei das Bestimmen des Defektstatus des wiederaufladbaren Akkus ein Berücksichtigen eines früheren Nutzungsmusters des wiederaufladbaren Akkus umfasst, wobei optional das frühere Nutzungsmuster mindestens eines von Folgenden umfasst: eine Temperatur des wiederaufladbaren Akkus; Lagerbedingungen des wiederaufladbaren Akkus; Lademuster des wiederaufladbaren Akkus; Entlademuster des wiederaufladbaren Akkus; oder eine Anzahl von Ladezyklen des wiederaufladbaren Akkus, wobei ferner optional die Lademuster mindestens eines von einer Laderate oder einer Ladetiefe umfassen oder wobei die Entlademuster mindestens eines von einer Entladerate oder einer Entladetiefe umfassen.

7. Verfahren nach einem der Ansprüche 1 bis 6, wobei der eine oder die mehreren Akkuparameter mindestens eines von Folgenden umfassen: eine Leerlaufspannung des wiederaufladbaren Akkus, eine Lastspannung des wiederaufladbaren Akkus, eine Ladeimpulsspannung des wiederaufladbaren Akkus, Informationen zur elektrochemischen Impedanzspektroskopie (EIS), die mit dem wiederaufladbaren Akku verknüpft sind, eine Kapazität des wiederaufladbaren Akkus, Impedanzinformationen, die mit dem wiederaufladbaren Akku verknüpft sind, oder einen Strom, der mit dem wiederaufladbaren Akku verknüpft ist.

8. Verfahren nach einem der Ansprüche 1 bis 7, ferner umfassend Modifizieren eines Nutzungsmusters des wiederaufladbaren Akkus mindestens teilweise basierend auf dem bestimmten Defektstatus des wiederaufladbaren Akkus (540).

9. Verfahren nach Anspruch 8, wobei das Modifizieren des Nutzungsmusters mindestens eines von Folgenden umfasst: Modifizieren eines Ladevorgangs, der zum Laden des wiederaufladbaren Akkus verwendet wird; Modifizieren eines Entladevorgangs, der zum Entladen des wiederaufladbaren Akkus verwendet wird; oder Modifizieren einer Temperatur des wiederaufladbaren Akkus, wobei optional das Modifizieren des Ladevorgangs ein vorübergehendes Verhindern des Ladens des wiederaufladbaren Akkus umfasst oder wobei das Modifizieren des Ladevorgangs ein Reduzieren einer Ladespannung und/oder eines Ladestroms umfasst.

10. Verfahren nach Anspruch 8 oder 9, wobei das modifizierte Nutzungsmuster auf einen gegebenen SOC des wiederaufladbaren Akkus oder einen Bereich von SOCs des wiederaufladbaren Akkus anwendbar ist.

11. Vorrichtung zum Diagnostizieren von Akkudefekten, umfassend:
eine Überwachungsschaltung (114), die mit dem wiederaufladbaren Akku (118) gekoppelt ist und konfiguriert ist, einen oder mehrere Akkuparameter zu überwachen, die mit dem wiederaufladbaren Akku verknüpft sind; und
eine Steuerschaltung (116), die mit der Überwachungsschaltung gekoppelt ist, wobei die Vorrichtung konfiguriert ist, das Verfahren nach einem der Ansprüche 1 bis 10 auszuführen.

## Revendications

1. Procédé (500) de diagnostic de défauts de batterie, le procédé comprenant :
la surveillance d'un ou plusieurs paramètres de batterie associés à une batterie rechargeable (510) ;
l'obtention d'un taux de variation d'au moins un paramètre de batterie parmi les un ou plusieurs paramètres de batterie (520) ; et
la détermination de l'état de défaut de la batterie rechargeable sur la base au moins en partie du taux de variation de l'au moins un paramètre de batterie (530),
dans lequel la détermination de l'état de défaut de la batterie rechargeable comprend la comparaison du taux de variation de l'au moins un paramètre de batterie à un taux de variation attendu de l'au moins un paramètre de batterie, et
dans lequel la comparaison se produit à un état de charge, SOC, prédéterminé, ou plage de SOC et/ou que le taux de variation attendu de l'au moins un paramètre de batterie est basé au moins en partie sur une sortie d'un modèle de batterie et/ou sur des données historiques provenant d'autres batteries rechargeables.

2. Procédé selon la revendication 1, dans lequel le taux de variation obtenu se produit sur au moins 2 cycles de la batterie rechargeable.

3. Procédé selon la revendication 1 ou 2, dans lequel le modèle de batterie comprend l'un ou plusieurs des éléments suivants : un modèle de circuit équivalent de la batterie rechargeable ; un modèle d'apprentissage automatique ; ou une expression mathématique et/ou dans lequel le modèle de batterie est spécifique à un type de batterie correspondant à la batterie rechargeable, éventuellement dans lequel le type de batterie correspond à au moins l'un des éléments suivants : une chimie de batterie associée à la batterie rechargeable ; un fournisseur de la batterie rechargeable, ou une conception de cellule associée à la batterie rechargeable.

4. Procédé selon l'une quelconque des revendications 1 à 3, dans lequel le modèle de batterie est applicable à un régime d'utilisation particulier de la batterie rechargeable.

5. Procédé selon la revendication 4, dans lequel le régime d'utilisation comprend au moins l'un des éléments suivants : une plage de SOC, une partie à courant constant d'un protocole de charge ; ou
une partie à tension constante du protocole de charge et/ou dans lequel le régime d'utilisation comprend au moins une partie d'un protocole de décharge.

6. Procédé selon l'une quelconque des revendications 1 à 5, dans lequel la détermination de l'état de défaut de la batterie rechargeable comprend la prise en compte d'un schéma d'utilisation antérieur de la batterie rechargeable, éventuellement dans lequel le schéma d'utilisation antérieur comprend au moins l'un des éléments suivants : une température de la batterie rechargeable ; des conditions de stockage de la batterie rechargeable ; des schémas de charge de la batterie rechargeable ; des schémas de décharge de la batterie rechargeable ; ou un nombre de cycles de charge de la batterie rechargeable, en outre éventuellement dans lequel les schémas de charge comprennent au moins l'un d'un taux de charge ou d'une profondeur de charge, ou dans lequel les schémas de décharge comprennent au moins l'un d'un taux de décharge ou d'une profondeur de décharge.

7. Procédé selon l'une quelconque des revendications 1 à 6, dans lequel les un ou plusieurs paramètres de batterie comprennent au moins l'un des éléments suivants : une tension en circuit ouvert de la batterie rechargeable, une tension en circuit chargé de la batterie rechargeable, une tension d'impulsion de charge de la batterie rechargeable, des informations de spectroscopie d'impédance électrochimique (EIS) associées à la batterie rechargeable, une capacité de la batterie rechargeable, des informations d'impédance associées à la batterie rechargeable ou un courant associé à la batterie rechargeable.

8. Procédé selon l'une quelconque des revendications 1 à 7, comprenant en outre la modification d'un schéma d'utilisation de la batterie rechargeable sur la base au moins en partie de l'état de défaut déterminé de la batterie rechargeable (540).

9. Procédé selon la revendication 8, dans lequel la modification du schéma d'utilisation comprend au moins l'une des actions suivantes : la modification d'un processus de charge utilisé pour charger la batterie rechargeable ; la modification d'un processus de décharge utilisé pour décharger la batterie rechargeable ; ou la modification de la température de la batterie rechargeable, éventuellement dans lequel la modification du processus de charge comprend l'interdiction temporaire de la charge de la batterie rechargeable ou dans lequel la modification du processus de charge comprend la réduction d'une tension de charge et/ou d'un courant de charge.

10. Procédé selon la revendication 8 ou 9, dans lequel le schéma d'utilisation modifié est applicable à un SOC donné de la batterie rechargeable ou à une plage de SOC de la batterie rechargeable.

11. Appareil de diagnostic de défauts de batterie, comprenant :
un circuit de surveillance (114), couplé à la batterie rechargeable (118), configuré pour surveiller un ou plusieurs paramètres de batterie associés à la batterie rechargeable ; et
un circuit de commande (116), couplé au circuit de surveillance, dans lequel l'appareil est configuré pour mettre en œuvre le procédé selon l'une quelconque des revendications 1 à 10.
